(19) Europäisches Patentamt European Patent Office Office européen des brevets

(11) **EP 4 675 928 A1**

(12) **EUROPÄISCHE PATENTANMELDUNG**

(43) Veröffentlichungstag:
07.01.2026 Patentblatt 2026/02

(21) Anmeldenummer: 24186427.1

(22) Anmeldetag: 04.07.2024

(51) Internationale Patentklassifikation (IPC):
$H03M\ 1/64^{(2006.01)}$ $H03C\ 1/52^{(2006.01)}$
$H03C\ 3/40^{(2006.01)}$

(52) Gemeinsame Patentklassifikation (CPC):
H03M 1/64; H03C 1/52; H03C 3/40

(84) Benannte Vertragsstaaten:
AL AT BE BG CH CY CZ DE DK EE ES FI FR GB GR HR HU IE IS IT LI LT LU LV MC ME MK MT NL NO PL PT RO RS SE SI SK SM TR
Benannte Erstreckungsstaaten:
BA
Benannte Validierungsstaaten:
GE KH MA MD TN

(71) Anmelder: Siemens Aktiengesellschaft
80333 München (DE)

(72) Erfinder:
• Griessbach, Gunter
09423 Gelenau (DE)

• Helmdach, Alexander
09130 Chemnitz (DE)
• Prochaska, Dirk
09127 Chemnitz (DE)
• Raab, Oliver
94496 Ortenburg (DE)
• Weikert, Robert
92342 Burggriesbach (DE)

(74) Vertreter: Siemens Patent Attorneys
Postfach 22 16 34
80506 München (DE)

(54) **EINGANGSEINRICHTUNG, STEUERUNG, MESSVORRICHTUNG UND VERWENDUNG**

(57) Die Erfindung betrifft eine Eingangseinrichtung (B) für eine Steuerung (S) oder für eine Messevorrichtung, wobei die Eingangseinrichtung (B) wenigstens eine Eingangsschaltung (1) umfasst, um wenigstens einen digitalen oder wenigstens einen analogen Eingang für eine Steuerung (S) oder Messvorrichtung bereitzustellen,
wobei die wenigstens eine Eingangsschaltung (1) wenigstens einen Phasenmodulationswandler (P) umfasst, wobei der wenigstens eine Phasenmodulationswandler (P) aufweist:
- einem Amplitudenmodulator (2) mit Trägerunterdrückung, dem ein Eingangssignal ($Sig_A$) eingangsseitig zugeführt werden kann, um ein trägerloses amplitudenmoduliertes Signal ($Sig_{AM}$) zu erhalten,
- einem Addierer (7), um zu dem trägerlosen amplitudenmodulierten Signal ($Sig_{AM}$) ein um 90° verschobenes Trägersignal ($Sig_{T90}$) zu addieren und ein phasenmoduliertes Signal ($Sig_{PM}$) zu erhalten,
- einem Begrenzer (11), dem das phasenmodulierte Signal ($Sig_{PM}$) zugeführt werden und mit dem eine Störamplitudenmodulation in dem phasenmodulierten Signal ($Sig_{PM}$) unterdrückt werden kann, und
- einer Demodulationseinrichtung (16), der das von dem Begrenzer (11) ausgegebene Signal ($Sig_{BA}$) zugeführt und darin mit wenigstens einem Abtast-Clocksignal (CLK0-CLK3) abgetastet werden kann.

FIG 2

**Beschreibung**

Die Erfindung betrifft eine Eingangseinrichtung, insbesondere Eingangsbaugruppe, für eine bevorzugt speicherprogrammierbare Steuerung oder für eine Messevorrichtung, insbesondere ein Oszilloskop oder ein bevorzugt digitales Multimeter, wobei die Eingangseinrichtung wenigstens eine Eingangsschaltung umfasst, um wenigstens einen digitalen oder wenigstens einen analogen Eingang für eine Steuerung oder Messvorrichtung bereitzustellen. Darüber hinaus betrifft die Erfindung eine Steuerung bzw. Messvorrichtung mit wenigstens einer solchen Eingangseinrichtung, die Verwendung einer solchen und die Verwendung eines Phasenmodulationswandlers.

Vor allem im industriellen Umfeld bestehen diverse Anforderungen an zum Einsatz kommende Steuerungen und Messvorrichtungen.

So gibt es Anforderungen an digitale Eingänge im Industrieumfeld. Hierzu gehört eine entsprechende Eingangskennlinie aus Strom und Spannung zur Kompatibilität mit gängigen Sensoren. Da im Industrieumfeld mehrere, verschiedene Eingangsspannungsbereiche verwendet werden (24VDC, 48VDC, 110VDC (Bahn) sowie 110/120/230 VAC), welche unterschiedliche Eingangskennlinien einhalten müssen, ist es eine Herausforderung einen digitalen Eingang aufzubauen, welcher über einen weiten Spannungsbereich genutzt werden kann. Daher ist es üblich, dass für die verschiedenen Eingangsspannungsklassen verschiedene Schaltungen realisiert werden. Dies führt zu erhöhter Bauteilvielfalt und höherem Wartungs- und Pflegeaufwand.

Auch besteht oftmals Bedarf daran, dass bei Steuerungen bzw. Messeinrichtungen eine Potentialtrennung zu einer Auswerglogik des Gerätes realisiert wird. Für digitale Eingänge nach SPS-Norm ist beispielsweise gefordert, dass eine galvanische Trennung zur Logik vorgesehen wird. Diese galvanische Trennung ist häufig eine Problemstelle, um die nach Norm geforderte EMV-Festigkeit einzuhalten. Damit sind zusätzliche EMV-Maßnahmen meist unumgehbar.

Der Anmelderin sind verschiedene Lösungsmöglichkeiten bekannt, um die Information eines digitalen Eingangs über eine Potentialtrennung zu bringen. Die einfachste Art besteht in der Verwendung von Optokopplern. Nachteilig ist hier, dass diese auf der Sendedioden-Seite stets einen bestimmten Strom benötigen, um die Information zuverlässig zu transportieren. Die Auswertung auf der Logikseite beruht auf dem Stromübertragungsfaktor des Optokopplers (CTR). Leider ist der Stromübertragungsfaktor von vielen Faktoren, wie dem LED-Strom selbst, der Umgebungstemperatur sowie sehr stark von der Alterung des Bauteils, abhängig. Dies hat zur Folge, dass für eine zuverlässige Informationsübertragung der Strom durch die Sender-LED überdimensioniert werden muss. Dieser Strom wird aus der z.B. 24V-Prozessseite entnommen und hat damit eine erhöhte Verlustleistung und in Konsequenz ein höheres Derating von SPS-Modulen zur Folge.

Eine Alternative zur optischen Übertragung besteht in der Verwendung von kapazitiven oder induktiven Datenkopplern. Diese Koppler dienen nur zur Übertragung der Information über die Potentialtrennung. Die entsprechenden Bauteile werden in Standard-Industrie-Pinouts gefertigt und sind häufig untereinander weitestgehend austauschbar. Nachteilig ist hier, dass der z. B. 24V digitale Eingang auf ein Logik-Spannungslevel (CMOS) herunterskaliert werden muss, dass eine für die Koppler brauchbare Versorgungsspannung zur Verfügung gestellt werden muss. Es gibt hier auch schon Datenkoppler mit integrierter Versorgungsspannung welche jedoch noch teurer sind als die reinen Datenkoppler selbst.

Der Anmelderin ist auch bekannt, dass es einige Lieferanten spezielle anwendungsspezifische integrierte Schaltungen (ASICs) anbieten, um die komplette Funktion von Kennlinie und Potentialtrennung gemeinsam in einem intergierten Schaltkreis (IC) anzubieten. Nachteilig ist hier, dass diese spezialisierten Lösungen keine Alternative am Markt haben. Wird ein Design mit entsprechenden ASICs aufgebaut, ist im Fall einer Bauteil/Lieferkriese kein alternativer Lieferant verfügbar.

Für den normgerechten Einsatz in Industrieanwendungen ist es nötig, ein Mindestmaß an elektromagnetischer Verträglichkeit (EMV) bzw. EMV-Festigkeit, zu erreichen. In der Vergangenheit hat es sich gezeigt, dass es vor allem an der schon beschriebenen Potentialtrennung zur Störbeeinflussung kommt. Egal, welches der genannten Übertragungsprinzipien (optisch, kapazitiv, induktiv) verwendet wird, es besteht immer eine Empfindlichkeit gegenüber transienten Störungen (common-mode und/oder differential). Damit eine entsprechende EMV-Festigkeit erreicht werden kann, war es daher immer notwendig, sowohl das Eingangssignal selbst entsprechend stark zu filtern (Anforderung 61000-4-6 HF Bestromung ab 10kHz), als auch dafür zu sorgen, dass im Falle einer schnellen Transiente (61000-4-4 Burst) der Gradient der Spannungsänderung zwischen den beiden angeschlossenen Potentialen im spezifizierten Rahmen bleibt. Die Kondensatoren, welche damit extern parallel zur Trennstrecke notwendig werden, treiben zum einen den Preis weiter in die Höhe und bringen Probleme bei Sicherheitsbetrachtungen für den gemischten Betrieb von Standard - und Failsafe Modulen, beispielsweise in einem SPS-Rack mit sich. Die Abkürzung SPS steht dabei in bekannter Weise für speicherprogrammierbare Steuerung.

Egal ob in SPS-Modulen digitale Eingänge, digitale Ausgänge oder die analogen Varianten realisiert werden müssen, besteht in der Regel immer die Anforderung an eine Potentialtrennung. Nun wäre es vorteilhaft, wenn dieser logische Block zusammen mit der Auswertelogik, z.B. in einem ASIC, aufgebaut werden könnte. Die vorgenannten Verfahren sind jedoch nur schwer integrierbar, da es sowohl einen Konflikt bezüglich der notwendigen Prozesse als auch bei der Aufbautechnik (z.B. mehrere Die's in einem Chip) gibt. Dies ist aktuell in großen Stückzahlen nicht wirtschaftlich realisierbar.

Eine weitere Problematik besteht darin, dass zusätzliche Mechanismen nötig sind, um Eingangssignale über mehrere Kanäle hinweg synchron einzulesen. Der Anmelderin ist ein Beispiel eines integrierten Schaltkreises bekannt, bei dem über einen extra Logik-Pin der Zeitpunkt getriggert wird. Diese Information wird intern über die Potentialtrennung übertragen und die Kanäle entsprechend freigegeben bzw. gesperrt. Um zu einer exakten Uhrzeit den Zustand der mehreren Eingangskanäle zu ermitteln, muss darüber hinaus ein Laufzeitausgleich in der Firmware erfolgen. Soll eine derartige Funktion auf Basis der Optokoppler-Schaltungen realisiert werden, sind zusätzliche Schaltelemente über die Potentialtrennung hinweg nötig.

Der Anmelderin sind ferner Lösungen bekannt, bei denen, wie in Industrieanwendungen üblich, mehrere Kanäle auf dem gleichen Bezugspotential liegen, in welchen isolierte Analog-Digital-Wandler den Zustand der angeschlossenen Eingänge abtasten. Durch die Verwendung von Synchronwandlern ist in diesem Fall der zeitliche Bezug der Signale zueinander klar definiert. Diese Lösung ist jedoch aufwändig und kostspielig.

Ein Analog-Digital-Wandler dient dazu, eine analoge Eingangsgröße in ein digitales Signal zu konvertieren. Bekannte Analog-Digital-Wandler sind z.B. der SAR-Wandler (Sukzessiv-Approximations-Wandler) und der Sigma-Delta-Wandler. Beide Wandlertypen sind mit Nachteilen verbunden, welche aus Gleichspannungsfehlern des analogen Eingangssignals resultieren.

Die EP 3 624 334 A1 offenbart eine weiterentwickelte Vorrichtung zur Wandlung eines analogen Eingangssignals in ein digitales Ausgangssignal. Konkret handelt es sich um einen Analog-Digital-Wandler (ADC-Wandler), der auf dem Unterschied der Phasenlage eines zur zu messenden Eingangsspannung modulierten Signals im Vergleich zu einem Referenzsignal basiert. Der aus der EP 3 624 334 A1 vorbekannte Analog-Digital-Wandler kann auch als Phasenmodulationswandler bezeichnet werden.

Der Phasenmodulationswandler gemäß der EP 3 624 334 A1 umfasst einen Amplitudenmodulator mit Trägerunterdrückung zur Bereitstellung eines trägerlosen amplitudenmodulierten Signals. Der Amplitudenmodulator weist ein Signaleingang auf, an dem ein analoges, zu wandelndes Eingangssignal zugeführt werden kann. Es ist ferner ein Addierer vorhanden, dem das von dem Amplitudenmodulator ausgegebene trägerlose amplitudenmodulierte Signal zugeführt wird und der dazu eingerichtet ist, zu diesem ein um 90° verschobenes Trägersignal zu addieren und ein phasenmoduliertes Signal bereitzustellen. Weiterhin ist ein Begrenzer vorhanden, dem das von dem Addierer ausgegebene, phasenmodulierte Signal zugeführt wird und der dazu ausgebildet ist, eine Störamplitudenmodulation in dem phasenmodulierten Signal zu unterdrücken.

Das resultierende Ausgangssignal des Begrenzers weist eine Amplitude auf, welche aus 0 oder 1 besteht. Man kann auch sagen, es liegt ein in der Amplitude digitales Signal vor. Die Länge dieser Impulse ist in Abhängigkeit der gewählten Trägerfrequenz wertkontinuierlich. Die Information steckt in der Länge der Rechteckpulse. Das Ausgangssignal des Begrenzers trägt die Modulation in zeitlich unterschiedlichen Nulldurchgängen im Vergleich zu dem 90°-Trägersignal. In diesem Zusammenhang sei auch auf die Figuren der EP 3 624 334 A1, insbesondere die darin enthaltenen Figuren 5 bis 8 nebst zugehöriger Beschreibung verwiesen, welche das Prinzip näher erläutern.

Ausgehend davon ist es eine Aufgabe der vorliegenden Erfindung, eine Vorrichtung der eingangs genannten Art anzugeben, welche eine gute EMV-Festigkeit bietet, sich mit vertretbarem Aufwand an verschiedene Spannungsbereiche anpassen und in mehrkanaliger Ausführung ausgestalten und gleichzeitig kostengünstig fertigen lässt.

Diese Aufgabe wird bei einer Eingangseinrichtung der eingangs genannten Art dadurch gelöst, dass die wenigstens eine Eingangsschaltung wenigstens einen Phasenmodulationswandler umfasst, wobei der wenigstens eine Phasenmodulationswandler aufweist:

- einem Amplitudenmodulator mit Trägerunterdrückung, dem ein Eingangssignal eingangsseitig zugeführt werden kann, um ein trägerloses amplitudenmoduliertes Signal zu erhalten,
- einem Addierer, um zu dem trägerlosen amplitudenmodulierten Signal ein um 90° verschobenes, bevorzugt sinusförmiges Trägersignal zu addieren und ein phasenmoduliertes Signal zu erhalten,
- einem Begrenzer, dem das phasenmodulierte Signal zugeführt werden und mit dem eine Störamplitudenmodulation in dem phasenmodulierten Signal unterdrückt werden kann, und
- einer Demodulationseinrichtung, der das von dem Begrenzer ausgegebene Signal zugeführt und darin mit wenigstens einem Abtast-Clocksignal abgetastet werden kann.

Die vorliegende Erfindung sieht mit anderen Worten vor, Eingänge von industriellen Steuerungen bzw. Messvorrichtungen basierend auf einem oder mehreren Phasenmodulationswandlern aufzubauen, was erhebliche Vorteile gegenüber konventionellen Eingangseinrichtungen bietet.

Zum einen kann eine Potentialtrennung beim einem Phasenmodulationswandler aufbaubedingt sehr einfach und günstig, z.B. durch Koppelkondensatoren, erfolgen. Dies praktisch an beliebiger Stelle des Signalpfades. Es sind keine intelligenten kapazitiven/induktiven Übertrager notwendig. Entsprechend zeichnet sich eine bevorzugte Ausgestaltung der erfindungsgemäßen Eingangseinrichtung dadurch aus, dass zwischen dem Amplitudenmodulator und der Demodulationseinrichtung des wenigstens einen Phasenmodulationswandlers wenigstens eine galvanische Trennung vorgesehen ist, die bevorzugt wenigstens ein Paar von Koppelkondensatoren umfasst oder dadurch gegeben ist.

Der Mechanismus des Phasenmodulationswandlers ist universell und kann leicht, z.B. in einen Bus-ASIC, integriert werden, insbesondere der Demodulierer des Phasenmodulationswandlers. Gerade weil der Ansatz diese Universalität mitbringt, kann eine Integration auf einfache Weise erfolgen. Ganz gleich, ob digitale oder analoge Eingangsbaugruppen aufgebaut werden sollen, die Art und Weise der Signalübertragung kann immer gleichbleiben und ist daher für ein großes Baugruppenspektrum nutzbar. Weiterhin ist die Integration der nötigen Komponenten deutlich leichter als die Integration von bisherigen Technologien bei denen häufig mehrere Chips, horizontal oder vertikal gestapelt, in ein Gehäuse gepackt werden. Alle nötigen Komponenten, die integriert werden müssen, basieren entweder auf Logikelementen oder auf einfachen analogen Schaltungen, was die Integration wesentlich vereinfacht. Ein Mixed-Signal-Prozess ist leichter und günstiger zu realisieren, als den erhöhten Aufwand in der Aufbau- und Verbindungstechnik für die Verbindung verschiedener Chips zu betreiben.

Da die Übertragung der Information beim Phasenmodulationswandler im Frequenzbereich stattfindet, ergibt sich ferner Prinzip-bedingt eine höhere EMV-Festigkeit. Im Vergleich zu kapazitiven/Induktiven Kopplern besteht keine Notwendigkeit zur Begrenzung der Anstiegszeit einer Common-Mode Störung, da diese an der Trennstelle unterdrückt wird. Damit kann auf große, teure Filterkondensatoren über die Trennstelle verzichtet werden, was die Integrierbarkeit sowie die Kostenposition verbessert. Der Vollständigkeit halber sei angemerkt, dass Kondensatoren über die Trennstelle hinweg verbaut sein bzw. werden können, dann aber insbesondere, um das Signal zu übertragen und nicht, um die Transiente zu bremsen. Der Vorteil liegt insbesondere darin, dass sich eine Transiente auf beide Leitungen einer differentiellen Übertragung auswirkt und damit im Nutzsignal quasi nicht ankommt.

Ein weiterer Vorteil der Nutzung eines Phasenmodulationswandlers für Eingänge von Steuerungen bzw. Messvorrichtung ist dadurch gegeben, dass ein Phasenmodulationswandler immer analog ist. Insbesondere für den Fall, dass ein Phasenmodulationswandler für einen digitalen Eingang verwendet wird, kann man auch sagen, dass das digitale Signal bzw. der digitale Zustand analog analysiert wird.

Bei einem Phasenmodulationswandler erfolgt keine Übertragung von "1 und 0", sondern eine analoge Abtastung insbesondere vom begrenzten Signal. Dies auch in demjenigen Falle, dass ein Phasenmodulationswandler für einen digitalen Eingang genutzt wird, mit anderen Worten für digitale Signale. Im analogen Bereich wird es möglich, neben den beiden Zuständen "1 und 0" noch Zusätzliches mit abzudecken, insbesondere einen dritten Zustand. Dies kann genutzt werden, um zusammen mit dem eigentlichen Signalzustand Diagnoseinformationen, etwa eine Information über einen Draht- bzw., Leitungsbruch, zu übertragen, dies ohne dass es hierfür eines zusätzlichen Kanals bedürfte. Gemäß dem Stand der Technik ist dies hingegen in der Regel nötig. Bei einem diagnosefähigen SPS-Kanal etwa wurde bisher über einen Optokoppler der Signalzustand und über einen weiteren Optokoppler die Information über den Draht-/Leitungsbruch übertragen. Bisher war mit anderen Worten für die Diagnosefunktion ein zusätzlicher Kanal über die Potentialtrennung hinweg nötig. Durch den Wegfall dieses Erfordernisses bei Nutzung eines Phasenmodulationswandlers können Kanäle mit Diagnosefunktion erhalten werden, mit denen deutlich weniger Aufwand und somit geringere Kosten einhergehen.

Vorteilhaft ist ferner, dass zur Realisierung von digitalen Eingängen für verschiedene Spannungsbereiche auf einfache Weise nur insbesondere dem Amplitudenmodulator des wenigstens einen Phasenmodulationswandlers vorgeschaltete Elemente, etwa ein diesem vorgeschaltetes Signalverarbeitungsmodul, angepasst werden kann, um die nach Norm geforderten Kennlinien einzuhalten. Der Funktionsblock der Informationsübertragung, auch über eine Potentialtrennung, kann universell gehalten werden. Insbesondere ist keine Änderung des (jeweiligen) Amplitudenmodulators, Addierers oder Begrenzers erforderlich. Es ergibt sich im Vergleich zu fertigen Kopplern ein zusätzlicher Freiheitsgrad. Je nach geforderter Luft- und Kriechstrecke muss nur der Abstand auf der Leiterplatte sowie die Spannungsfestigkeit der Koppelkondensatoren einer zweckmäßiger Weise vorhandenen galvanischen Trennung angepasst werden.

Weiterhin ist aufbaubedingt mit dem Amplitudenmodulator schon ein Element vorhanden, welches implizit ein "gating" des Eingangszustandes zu einem bestimmten Zeitpunkt übernimmt. Der Amplitudenmodulator kann insbesondere als Schaltermodulator, bevorzugt CMOS-Schaltermodulator, ausgebildet sein oder wenigstens einen solchen umfassen. Besteht die Anforderung an schnelle, taktsynchron eingelesene Eingangskanäle, kann diese Funktion schon überwiegend durch den Phasenmodulationswandler abgedeckt werden.

In zweckmäßiger Ausgestaltung gilt, dass das Eingangssignal dem Amplitudenmodulator mit Trägerunterdrückung an einem Eingang zugeführt wird und dass dem Amplitudenmodulator an einem weiteren Eingang ein insbesondere rechteck- oder sinusförmiges Trägersignal zugeführt wird. Die erfindungsgemäße Vorrichtung kann entsprechend ausgebildet und/oder eingerichtet sein. Das um 90° phasenversetzte Trägersignal, was mittels des Addierers zu dem amplitudenmodulierten Signal hinzuaddiert wird, ist zweckmäßiger Weise um 90° zu demjenigen Trägersignal phasenversetzt, das dem Amplitudenmodulator zugeführt wird. Es gilt insbesondere, dass die Frequenz dieses Trägersignals der Modulatorfrequenz entspricht. Dieses Trägersignal stellt ferner insbesondere einen zu unterdrückenden Träger dar.

Mit anderen Worten gilt insbesondere, dass das phasenmodulierte Signal gebildet wird aus Amplitudenmodulation des Eingangssignales mit einem Träger und dieser Träger im Amplitudenmodulator unterdrückt wird. Das trägerlose Zweiseitenbandsignal wird mit einem 90°-Träger addiert. Nach Begrenzung dieses Signales steht ein phasenmoduliertes Signal zur Verfügung. Das Zweiseitenband-Signal enthält Seitenbänder mit jeweils gleicher Information. Durch die Erzeugung eines amplitudenmodulierten Signals mit Trägerunterdrückung entfällt die aufwändige Kompensation des in der Amplitudenmodulation enthaltenen Trägers. Durch die Addition eines neuen Trägers, welcher um 90° gegenüber dem Träger, der zu dem AM-Signal gehört, gedreht wird, erhält man ein phasenmoduliertes Signal mit maximal +/- 90° Phasenhub.

Bei dem Eingangssignal, das dem Amplitudenmodulator mit Trägerunterdrückung eingangsseitig zugeführt wird, kann es sich zum Beispiel um ein zu wandelndes analoges Eingangssignal handeln. Es kann aber auch ein digitales Signal sein bzw. ein insbesondere für übergeordnete Steuerungen digital zu interpretierendes Signal darstellen, welches vorerst analog behandelt wird.

Bei dem Amplitudenmodulator mit Trägerunterdrückung kann es sich beispielsweise um einen (digitalen) Schaltermodulator, etwa Doppelgegentaktmodulator, oder auch einen (digitalen) Ringmodulator handeln. Der Schaltermodulator umfasst bevorzugt wenigsten einen insbesondere digitalen Schalter und/oder wenigstens ein mechanisches Relais und/oder wenigstens ein Reed-Relais und/oder wenigstens einen MEMS-Schalter oder ist dadurch gegeben. Die Abkürzung MEMS steht hierbei in bekannter Weise für "Micro-Electro-Mechanical Systems".

Zweckmäßiger Weise gilt, dass insbesondere ab dem Ausgang des Amplitudenmodulators und/oder bis zum Ausgang des Begrenzers bzw. Eingangs der Demodulationseinrichtung eine differentielle Signalübertragung erfolgt. Die erfindungsgemäße Vorrichtung ist in Weiterbildung entsprechend ausgestaltet. Man kann auch sagen, dass dann zumindest beginnend vom Ausgang des Amplitutenmodulators und insbesondere zumindest bis hin zum Ausgang des Begrenzers bzw. bis hin zur Demodulationseinrichtung feine differentielle Signalübertragung aufgebaut wird.

Der Addierer kann wenigstens einen Operationsverstärker umfassen oder dadurch gegeben sein. Es kann sich insbesondere um wenigstens einen volldifferentiellen Operationsverstärker handeln.

Bevorzugt wird mittels der Demodulationseinrichtung eine Flächenüberlappung zwischen dem begrenzten Signal und dem Referenzsignal berechnet, dies insbesondere über mehrere Perioden. Die Demodulationseinrichtung kann entsprechend ausgebildet und/oder eingerichtet sein.

Als besonders vorteilhaft hat sich erwiesen, wenn die Modulatorfrequenz im Bereich von 1 MHz bis 50 MHz liegt. Dies auch, das sich in diesem Frequenzbereich Filter kompakt realisieren lassen.

Als besonders vorteilhaft hat sich ferner erwiesen, wenn das von dem Begrenzer ausgegebene Signal in der Demodulationseinrichtung nicht nur mit einem, sondern mit mehreren zueinander phasenverschobenen Abtast-Clocksignalen abgetastet wird. Beispielsweise können zwei, drei, vier oder auch mehr Abtast-Clocksignale für die Abtastung genutzt werden. Kommen mehrere Abtast-Clocksignale zum Einsatz, gilt zweckmäßigerweise, dass diese fest zueinander phasenversetzt, mit anderen Worten phasenverschoben, sind. Der feste Phasenversatz wird dabei zweckmäßigerweise in Abhängigkeit der Anzahl der mehreren Abtast-Clocksignale gewählt. Der feste Phasenversatz beträgt insbesondere Worten 360°/m, wobei m der Anzahl der mehreren, für die Abtastung genutzten Abtast-Clocksignale entspricht. Die Demodulationseinrichtung kann entsprechend ausgebildet und/oder eingerichtet sein.

In weiterer vorteilhafter Ausgestaltung ist vorgesehen, dass die Phasenlage des wenigstens einen für die Abtastung genutzten Abtast-Clocksignals zur Erzielung einer erhöhten Auflösung dynamisch geändert wird, insbesondere um Schritte von weniger als 40°, bevorzugt um Schritte von weniger als 20°, besonders bevorzugt um Schritte von weniger als 10°. Die Demodulationseinrichtung des wenigstens einen Phasenmodulationswandlers der erfindungsgemäßen Eingangseinrichtung ist in vorteilhafter Weiterbildung entsprechend ausgebildet und/oder eingerichtet, umfasst beispielsweise zugehörige Mittel. Dass die Phasenlage des einen Abtast-Clocksignals oder der mehreren Abtast-Clocksignale dynamisch geändert wird, bedeutet insbesondere, dass die Phasenlage mehrfach, wiederkehrend, bevorzugt zyklisch, kontinuierlich bzw. quasi-kontinuierlich, verändert wird. Aufgrund der dynamischen Phasenverschiebung ändert sich die Phasenlage des - oder im Falle mehrerer insbesondere aller - Abtast-Clocksignale wiederkehrend, etwa zyklisch, in feinen Schritten. Die Veränderung erfolgt dabei insbesondere zur Laufzeit, etwa Programmlaufzeit der für die Demodulation genutzten Demodulationseinrichtung, die wenigstens einen FPGA und/oder ASIC umfassen oder durch wenigstens einen FPGA und/oder ASIC gegeben sein und entsprechend ausgebildet und/oder eingerichtet sein kann. Die Demodulationseinrichtung kann insbesondere ausgebildet und/oder eingerichtet sein, um Phasenlage des wenigstens einen Abtast-Clocksignals an mehreren aufeinanderfolgenden, insbesondere äquidistant voneinander beabstandeten Zeitpunkten zu ändern, bevorzugt, wobei zwischen den beabstandeten Zeitpunkten jeweils wenigstens eine Mikrosekunde liegt. Der zeitliche Abstand zwischen aufeinanderfolgenden Zeitpunkten der Phasenlagenänderung kann beispielsweise im Bereich von 2 bis 50 Mikrosekunden, bevorzugt im Bereich von 5 bis 50 Mikrosekunden, liegen.

Werden mehrere Abtast-Clocksignale für die Abtastung genutzt, werden diese in vorteilhafter Ausgestaltung alle dynamisch in ihrer Phasenlage geändert. Die dynamische, schrittweise Phasenlagenänderung der mehreren Abtast-Clocksignale erfolgt dabei zweckmäßiger Weise jeweils synchron und/oder um gleiche große Schritte, insbesondere von weniger als 40°. Es gilt ferner zweckmäßiger Weise, dass die dynamische, schrittweise Phasenlagenänderung der mehreren Abtast-Clocksignale derart erfolgt, dass der festen Phasenversatz, den die mehreren Abtast-Clocksignale zueinander haben, aufrecht erhalten bleibt. Eine Takterzeugungseinrichtung der Demodulationseinrichtung kann entsprechend ausgebildet und/oder eingerichtet sein.

Dabei sei betont, dass eine Auflösungserhöhung durch die dynamische Phasenverschiebung rein optional ist. Insbesondere für den Fall, dass einer oder mehrere digitale Eingänge bereitgestellt werden, kann in der Regel auch eine niedrigere Auflösung ausreichen. Entsprechend ist es auch möglich, die Modulatorfrequenz des Amplitudenmodulators zu erhöhen. Damit steigt zum einen die Datenrate und zum anderen können Filterelemente nochmals wesentlich kleiner werden.

Es wäre auch denkbar, integrierte Filter, wie sie z.B. im RFID / ISM Bereich in hohen Stückzahlen genutzt werden, einzusetzen. Beispielhaft seien Filter für Frequenzen von 13,56 MHz oder 27 MHz oder 40 MHz oder 433 MHz genannt. Die erfindungsgemäße Eingangseinrichtung kann sich in Weiterbildung entsprechend dadurch auszeichnen, dass sie wenigstens einen Filter aufweist, der für eine Frequenz von 13,56 MHz oder 27 MHz oder 40 MHz oder 433 MHz ausgebildet ist. Insbesondere gilt, dass der wenigstens eine Phasenmodulationswandler der erfindungsgemäßen Eingangseinrichtung wenigstens einen insbesondere analogen Filter aufweist, der für eine Frequenzen von 13,56 MHz oder 27 MHz oder 40 MHz oder 433 MHz ausgebildet ist.

Die erfindungsgemäße Eingangseinrichtung definiert bzw. implementiert wenigstens einen Eingang bzw. stellt wenigstens einen solchen bereit. Ist die erfindungsgemäße Eingangseinrichtung in bestimmungsgemäßer Weise in einer Steuerung, etwa SPS, oder einer Messvorrichtung, etwa einem Oszilloskop oder Multimeter, verbaut, stellt deren wenigstens eine Eingangsschaltung wenigstens einen Eingang der Steuerung bzw. Messvorrichtung bereit bzw. definiert bzw. implementiert wenigstens einen solchen.

Die erfindungsgemäße Eingangseinrichtung umfasst zweckmäßiger Weise wenigstens einen Eingangsanschluss, etwa wenigstens einen Eingangspin. Die wenigstens eine Eingangsschaltung der erfindungsgemäßen Eingangseinrichtung kann mit dem wenigstens einen Eingangsanschluss, insbesondere Eingangspin, beginnen. Wenigstens ein Eingangsanschluss kann mit anderen Worten eine erste Komponente der bzw. der jeweiligen Eingangsschaltung sein. Die Eingangsschaltung kann aber prinzipiell auch nach einem oder mehreren Eingangsanschlüssen beginnen, sich etwa an diese anschließen.

Die erfindungsgemäße Eingangseinrichtung kann nur einen oder auch mehrere analoge Eingänge und/oder nur einen oder auch mehrere digitale Eingänge für eine Steuerung oder Messvorrichtung bereitstellen bzw. implementieren.

So kann zum Beispiel eine mehrkanalige Ausgestaltung vorliegen. Im Vergleich zu der Realisierung eines konventionellen ADCs auf der Prozessseite hat der Phasenmodulationswandler den weiteren Vorteil, dass dann nicht ein separater kompletter Wandler pro Kanal aufgebaut werden muss. Es reicht insbesondere aus, wenn pro Kanal ein Amplitudenmodulator, Addierer und Begrenzer vorhanden sind, während eine zentrale Demodulationseinrichtung für mehrere Kanäle genutzt werden kann. Mehrere Kanäle können mit anderen Worten insbesondere durch Skalierung der der Demodulationseinrichtung vorgeschalteten Element bei gleichzeitiger Nutzung einer einzigen, zentralen Demodulationseinrichtung realisiert werden. Eine Skalierung sämtlicher Komponenten der Demodulationseinrichtung, die auch als Demodulator bezeichnet werden kann, ist nicht nötig. Insbesondere müssen nicht mehrere FPGAs und/oder ASICS vorgesehen werden. Eine Skalierung innerhalb der Demodulationseinrichtung, etwa innerhalb eines FPGAs bzw. ASICs, auf mehrere Kanäle, welche gleichzeitig gewandelt werden, kann vorgesehen sein und ist ohne Probleme möglich. Dies bietet im direkten Vergleich deutliche Kostenvorteile.

In besonders vorteilhafter Ausgestaltung der erfindungsgemäßen Eingangseinrichtung ist entsprechend vorgesehen, dass der wenigstens eine Phasenmodulationswandler mehrkanalig ausgebildet ist. Durch vorsehen eines mehrkanaligen Phasenmodulationswandlers kann auf besonders einfache Weise eine mehrkanalige Eingangseinrichtung erzielt werden. Eine solche weist zweckmäßiger Weise mehrere Eingangsanschlüsse, etwa Eingangspins, konkret für jeden Kanal eine auf.

Weiter bevorzugt kann gelten, dass der wenigstens eine mehrkanalige Phasenmodulationswandler eine zentrale Demodulationseinrichtung und für jeden Kanal einen eigenen Amplitudenmodulator, einen eigenen Addierer und einen eigenen Begrenzer umfasst, wobei die Begrenzer der mehreren Kanäle mit der zentralen Demodulationseinrichtung verbunden sind, so dass der zentralen Demodulationseinrichtung von den mehreren Begrenzern jeweils ausgegebene Signale zugeführt werden und darin mit wenigstens einem Abtast-Clocksignal abgetastet werden können. Die Verbindung ist eine signaltechnische Verbindung. Die mehreren Begrenzer können direkt oder auch über weitere Elemente mit der zentralen Demodulationseinrichtung verbunden sein.

Vor allem im industriellen Umfeld existieren oftmals Anwendungen, bei denen mehrere Kanäle prozessseitig auf einem gemeinsamen Massepotential arbeiten. Die erfindungsgemäße Eingangseinrichtung kann entsprechend ausgebildet und/oder eingerichtet sein.

Die erfindungsgemäße Eingangseinrichtung kann ferner wenigstens ein Signalverarbeitungsmodul umfassen. Dieses ist dann insbesondere dem wenigstens einen Phasenmodulationswandler vorgeschaltet. Bevorzugt gilt, dass das wenigstens eine Signalverarbeitungsmodul wenigstens einen Widerstand und/oder wenigstens eine Diode, insbesondere Zener-Diode, und/oder wenigstens einen Transistor umfasst. Ein Ausgang des bzw. des jeweiligen Signalverarbeitungsmoduls kann mit einem Eingang des bzw. des jeweiligen Amplitudenmodulators verbunden sein, direkt oder auch über weitere Elemente. Weist die Eingangseinrichtung wenigstens einen mehrkanaligen Phasenmodulationswandler auf, gilt zweckmäßiger Weise, dass dem Phasenmodulationswandler mehrere, insbesondere eine der Anzahl der Kanäle entsprechende Anzahl von Signalverarbeitungsmodul vorgeschaltet ist, wobei je ein Signalverarbeitungsmodul je einem der Kanäle zugeordnet ist.

In Steuerungen, etwa SPS-Modulen, mit mehreren digitalen Kanälen kann sich je nach Anwendungsfall bzw. Benutzerapplikation die Anforderung ergeben, dass alle anliegenden Kanäle zu einem festen Zeitpunkt eingefroren und gelesen werden. Vor allem bei potentialgetrennten Kanälen stellt dies eine Herausforderung dar, welche auf die erfindungsgemäße Weise unter Nutzung wenigstens eines Phasenmodulationswandlers besonders einfach gelöst werden kann.

Bei mehrkanaliger Ausgestaltung kann in Weiterbildung vorgesehen sein, dass die Amplitudenmodulatoren der mehreren Kanäle mit der zentralen Demodulationseinrichtung verbunden sind. Auch hier gilt, dass die Verbindung eine signaltechnische ist und diese sowohl direkt als auch über weitere Elemente vorliegen sein kann.

Weiter bevorzugt gilt dann, dass die Eingangseinrichtung derart ausgebildet und/oder eingerichtet ist, dass die Amplitudenmodulatoren der mehreren Kanäle mittels der zentralen Demodulationseinrichtung, insbesondere einer Takterzeugungseinrichtung dieser, getaktet werden können, und/oder dass den Amplitudenmodulatoren der mehreren Kanäle wenigstens ein von der zentralen Demodulationseinrichtung, insbesondere einer Takterzeugungseinrichtung dieser, erzeugtes Trägersignal zugeführt werden kann.

Dann kann auch auf besonders einfache Weise ein "gating" des Eingangszustandes zu einem bestimmten Zeitpunkt taktsynchron für die mehreren Kanäle bzw. von diesen definierten Eingänge erreicht werden.

Die erfindungsgemäße Eingangseinrichtung kann als Eingangsbaugruppe von einer bzw. für eine insbesondere industrielle Steuerung bzw. von einer oder für eine insbesondere industrielle Messvorrichtung ausgebildet sein. Die erfindungsgemäße Eingangseinrichtung kann modular ausgebildet sein.

Weist die erfindungsgemäße Eingangseinrichtung mehr als ein Eingangsschaltung auf, um mehr als einen Eingang bereitzustellen, kann vorgesehen sein, dass jede Eingangsschaltung wenigstens einen Phasenmodulationswandler umfasst.

Umfasst die erfindungsgemäße Eingangseinrichtung wenigstens eine mehrkanaligen Phasenmodulationswandler, kann jeweils einer der Kanäle einen Eingang bilden bzw. implementieren.

Eine weitere besonders vorteilhafte Ausführungsform zeichnet sich ferner dadurch aus, dass die Demodulationseinrichtung des wenigstens einen Phasenmodulationswandlers wenigstens einen FPGA und/oder wenigstens einen ASIC umfasst bzw. auf wenigstens einem FPGA und/oder auf wenigstens einem ASIC implementiert ist.

Weiterer Gegenstand der Erfindung ist eine Steuerung, insbesondere speicherprogrammierbare Steuerung, die wenigstens eine erfindungsgemäße Eingangseinrichtung umfasst. In diesem Falle hat sich als ganz besonders geeignet erwiesen, wenn zumindest die Demodulationseinrichtung des wenigstens einen Phasenmodulationswandlers der Eingangseinrichtung auf einem Rückwandbus-ASIC der Steuerung implementiert ist. Die Demodulationseinrichtung und gegebenenfalls weitere Komponenten der Eingangseinrichtung können mit anderen Worten direkt in einen Rückwandbus-ASIC der Steuerung integriert werden, was sich als besonders platzsparend und effizient erwiesen

Die Erfindung betrifft auch eine Messvorrichtung, insbesondere ein Oszilloskop oder bevorzugt digitales Multimeter, die wenigstens eine erfindungsgemäße Eingangseinrichtung umfasst.

Die erfindungsgemäße Eingangseinrichtung definiert dann zweckmäßiger Weise wenigstens einen digitalen und/oder wenigstens einen analogen Eingang der Steuerung/Messvorrichtung bzw. stellt einen solchen bereit. Es kann sich um eine (modulare) Eingangsbaugruppe handeln, die Bestandteil der Steuerung oder Messvorrichtung ist und einen oder mehrere Eingänge dieser bereitstellt.

Es sei angemerkt, das im industriellen Umfeld die Eingangsgrößen bzw. Eingangssignale, die beispielsweise von wenigstens einem Sensor, etwa einem solchen zur Erfassung eines Druckes, einer Temperatur oder auch einer anderen physikalischen Messgröße, stammen können, in der Regel analog sind. Auch ein digitaler Eingang - bzw. digitaler Kanal eines solchen - kann entsprechend für analoge Signale genutzt werden und wird in der Regel für solche genutzt. Unter einem digitalen Eingang - bzw. Kanal eines solchen- ist insbesondere ein Eingang bzw. Kanal zu verstehen, bei dem bzw. in dem eine Interpretation der Information in zwei Zuständen möglich ist bzw. erfolgt.

Gegenstand der Erfindung ist auch die Verwendung einer erfindungsgemäßen Eingangseinrichtung in einer insbesondere speicherprogrammierbaren Steuerung oder einer Messvorrichtung, insbesondere einem Oszilloskop oder bevorzugt digitalen Multimeter.

Schließlich ist Gegenstand der Erfindung die Verwendung eines Phasenmodulationswandlers, umfassend

- einen Amplitudenmodulator mit Trägerunterdrückung, dem ein Eingangssignal eingangsseitig zugeführt werden kann, um ein trägerloses amplitudenmoduliertes Signal zu erhalten,
- einen Addierer, um zu dem trägerlosen amplitudenmodulierten Signal ein um 90° verschobenes, bevorzugt sinusförmiges Trägersignal zu addieren und ein phasenmoduliertes Signal zu erhalten,

- einen Begrenzer, dem das phasenmodulierte Signal zugeführt werden und mit dem eine Störamplitudenmodulation in dem phasenmodulierten Signal unterdrückt werden kann, und
- eine Demodulationseinrichtung, der das von dem Begrenzer ausgegebene Signal zugeführt und darin mit wenigstens einem Abtast-Clocksignal abgetastet werden kann,

in einer Eingangsschaltung einer bevorzugt speicherprogrammierbaren Steuerung oder in einer Eingangsschaltung einer Messvorrichtung, insbesondere eines Oszilloskops oder eines bevorzugt digitalen Multimeters.

Es kann vorgesehen sein, dass die erfindungsgemäße Eingangseinrichtung zur gemeinsamen Übertragung von Signalinformationen und Diagnoseinformationen über einen Kanal verwendet wird. In gleicher Weise kann vorgesehen sein, dass der Phasenmodulationswandler zur gemeinsamen Übertragung von Signalinformationen und Diagnoseinformationen über einen Kanal verwendet wird.

Weitere Vorteile und Merkmale der vorliegenden Erfindung werden anhand der nachfolgenden Beschreibung unter Bezugnahme auf die beiliegende Zeichnung deutlich. Darin zeigt

Figur 1    eine rein schematische Darstellung eines Ausführungsbeispiels einer erfindungsgemäßen speicherprogrammierbaren Steuerung, die wenigstens eine erfindungsgemäße Eingangsbaugruppe umfasst,

Figur 2    eine rein schematische, vergrößerte Darstellung der Eingangsbaugruppe der Steuerung aus Figur 1,

Figur 3    Takterzeugungseinrichtung, XOR-Modul, Integrator und weitere Komponenten der Demodulationseinrichtung der Eingangsbaugruppe aus Figur 2 in vergrößerter, rein schematischer Darstellung,

Figur 4    Takterzeugungseinrichtung, XOR-Modul, Integrator und weitere Komponenten einer alternativ ausgestalteten Demodulationseinrichtung für die Nutzung von vier Abtast-Clocksignalen in vergrößerter, rein schematischer Darstellung,

Figur 5    die drei Takterzeugungsblöke der Takterzeugungseinrichtung der Demodulationseinrichtungen gemäß den Figuren 3 und 4 in vergrößerter, rein schematischer Darstellung,

Figur 6    in rein schematischer Darstellung eine weiteres Ausführungsbeispiel einer erfindungsgemäßen Eingangsbaugruppe in mehrkanaliger Ausgestaltung, und

Figur 7    die Demodulationseinrichtung der mehrkanaligen Eingangsbaugruppe aus Figur 6 in vergrößerter, rein schematischer Darstellung.

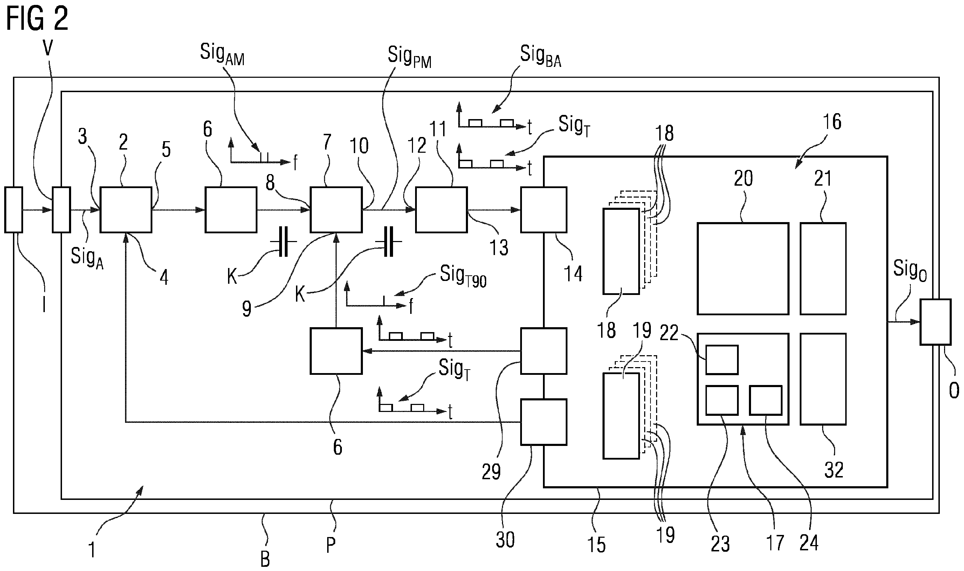

In den Figuren sind gleiche bzw. ähnliche Elemente und Komponenten mit gleichen Bezugszeichen versehen.

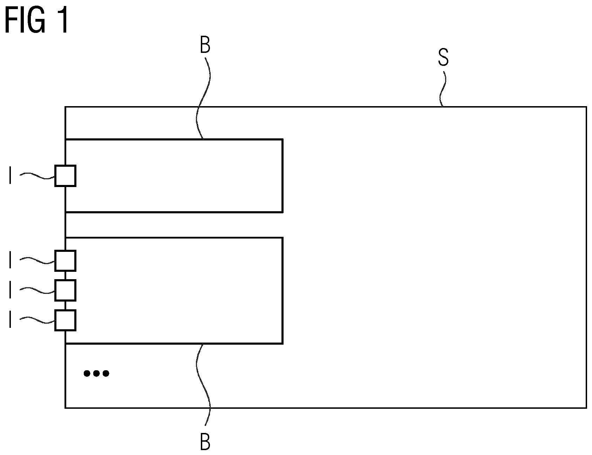

Die Figur 1 zeigt in vereinfachter, schematischer Blockdarstellung ein Ausführungsbeispiel einer erfindungsgemäßen Steuerung S. Diese ist vorliegend als speicherprogrammierbare Steuerung, kurz SPS, ausgebildet.
Die Steuerung S umfasst wenigstens eine Eingangseinrichtung, dies in Form einer bevorzugt modularen Eingangsbaugruppe B. In der Figur 1 sind zwei Eingangsbaugruppen B gezeigt, eine einkanalige mit einem Eingangsschluss, insbesondere Eingangspin I und eine mehrkanalige mit drei eingangsseitigen Anschlüssen bzw. Anschlussstellen I. Dies ist jedoch rein beispielhaft zu verstehen. Die Steuerung S kann auch nur eine Eingangsbaugruppe B oder mehr als zwei Eingangsbaugruppen B umfassen, die jeweils sowohl ein- als auch mehrkanalig ausgebildet sein können. Auch die Anzahl von drei Eingangsanschlüssen I bei der mehrkanaligen Variante aus Figur 1 ist rein beispielhaft. Eine mehrkanalige Eingangsbaugruppe gemäß der vorliegenden Erfindung kann auch nur zwei oder mehr als 3, etwa 4, 5, 6, 7, 8 oder mehr Eingänge für die Steuerung S definieren. Die eingangsseitigen Anschlüsse bzw. Anschlussstellen I der Eingangsbaugruppen B bilden eingangsseitige Anschlüsse bzw. Anschlussstelle I der Steuerung S.
Auch ist es beispielhaft zu verstehen, dass die in Figur 1 gezeigte Vorrichtung als Steuerung S ausgebildet ist. Diese könnte alternativ auch durch eine Messvorrichtung gegeben sein, wobei beispielhaft für eine solche ein Oszilloskop oder ein (digitales) Multimeter genannt seien.
Die bzw. im Falle mehrerer die jeweilige Eingangsbaugruppe B (vgl. die Figuren 1 und 2) umfasst wenigstens eine Eingangsschaltung 1, um wenigstens einen digitalen und/oder wenigstens einen analogen Eingang für die Steuerung S oder Messvorrichtung bereitzustellen.
Im Folgenden wird beispielhaft eine Eingangsschaltung 1 näher beschrieben.
Wie man der vergrößerten Darstellung aus Figur 2 entnehmen kann, weist die Eingangsschaltung 1 neben der eingangsseitigen Anschlussstelle I eine ausgangsseitige Anschlussstelle O auf, die bei dem dargestellten Beispiel auch entsprechende Anschlussstellen der Eingangsbaugruppe B bilden. Bei den Anschlussstellen I,O kann es sich z.B. um Anschlusspins handeln. Die Eingangsschaltung 1 umfasst ferner optional ein der eingangsseitigen Anschlussstelle I nachgeschaltetes, insbesondere der Signalkonditionierung dienendes Signalverarbeitungsmodul V, welches beispielsweise wenigstens einen Widerstand und/oder wenigstens eine Diode, insbesondere Zener-Diode, und/oder wenigstens einen Transistor aufweist, die in der vereinfachten Figur 2 nicht separat dargestellt sind.

An das Signalverarbeitungsmodul V schließt sich ein Phasenmodulationswandler P an. Dieser stellt einen Analog-Digital-Wandler dar. Das Eingangssignal $Sig_A$, bei dem es sich um eine analoges, jedoch auch ein digitales Signal handeln kann, kann über die Anschlussstelle I zugeführt werden, und über das optional vorgesehene Signalverarbeitungsmodul V zu dem Phasenmodulationswandler P gelangen. Der Phasenmodulationswandler P umfasst einen Amplitudenmodulator 2 mit Trägerunterdrückung, dem ein Eingangssignal $Sig_A$ an einem Eingang 3 zugeführt werden kann bzw. im Betrieb wird. Der Amplitudenmodulator 2 ist ausgebildet, um aus dem Eingangssignal $Sig_A$ ein trägerloses amplitudenmoduliertes Signal $Si\text{-}g_{AM}$ zu erhalten, welches mittels zwei differentieller Leitungen an die nachfolgenden Stufen übertragen wird. Es sei angemerkt, dass in den Figuren nicht beide Leitungen für die differentielle Übertragung separat dargestellt sind, sondern der Übersichtlichkeit halber nur eine. Bei dem Amplitudenmodulator 2 kann es sich beispielswiese um einen Schaltermodulator oder einen Ringmodulator handeln. Ein Schaltermodulator kann dabei wenigsten einen insbesondere digitalen Schalter und/oder wenigstens ein mechanisches Relais und/oder wenigstens ein Reed-Relais und/oder wenigstens einen MEMS-Schalter umfassen oder dadurch gegeben sein.

An einem zweiten Eingang 4 wird dem Amplitudenmodulator 2 ein rechteck- oder sinusförmiges Trägersignal $Sig_T$ zugeführt, auf dessen Erzeugung weiter unten noch näher eingegangen wird. Aus dem Ausgang 5 des Amplitudenmodulators 2 tritt das amplitudenmodulierte Signal $Sig_{AM}$ als differentielles Signal aus.

Das amplitudenmodulierte Signal $Sig_{AM}$ passiert anschließend einen dem Amplitudenmodulator 2 nachgeschalteten analogen Filter 6 und wird einem wiederum nachgeschalteten Addierer 7 der Vorrichtung 1 über dessen Eingang 8 zugeführt. An einem weiteren Eingang 9 wird dem Addierer 7 ein weiteres rechteckförmiges oder sinusförmiges Trägersignal $Sig_{T90}$ zugeführt, das um 90° zu dem sinusförmigen Trägersignal $Sig_T$ phasenverschoben ist. Durch Addition des trägerlosen amplitudenmodulierten Signals $Sig_{AM}$ und des sinusförmigen Trägersignals $Sig_{T90}$ wird ein phasenmoduliertes Signal $Sig_{PM}$ mit Störamplitudenmodulation erhalten.

Das Signal $Sig_{PM}$ wird an einem Ausgang 10 des Addierers 7 ausgegeben und einem Begrenzer 11 über dessen Eingang 12 zugeführt. Der Begrenzer 11 ist dazu ausgebildet, eine Störamplitudenmodulation in dem Signal $Sig_{PM}$ zu unterdrücken. Das erhaltene Signal $Sig_{BA}$, das vorliegend auch als begrenztes Signal bezeichnet wird, tritt an dem Ausgang 13 des Begrenzers 11 aus.

Das Signal $Sig_{BA}$ trägt die Modulation nun in zeitlich unterschiedlichen Nulldurchgängen im Vergleich zu dem 90°-Trägersignal $Sig_{T90}$ bzw. dem unterdrückten Trägersignal $Sig_T$. Dies ist in Figur 2 oben rechts des Begrenzers 11 rein schematisch dargestellt. Zu erkennen sind, jeweils in einem Graphen über der Zeit dargestellt, das Signal $Sig_{BA}$ (oben) und das Signal $Sig_T$ (unten) sowie der zeitliche Versatz $\Delta t$. Die Amplitude des Signals $Sig_{BA}$ schwankt zwischen 0 und 1, d.h. man hat ein in der Amplitude digitales Signal erhalten.

Das begrenzte Signal $Sig_{BA}$ wird einem Eingang 14 eines digitalen Schaltungsteils 15 zugeführt, welches der Demodulation des Signals $Sig_{BA}$ und optional weiteren Zwecken dient. Es sei angemerkt, dass, auch wenn in Figur 2 zwischen dem Bregenzer 11 und dem digitalen Schaltungsteil 15 keine weiteren Komponenten gezeigt sind, keineswegs ausgeschlossen ist, dass solche vorhanden sind. Das begrenzte Signal $Sig_{BA}$ kann dem digitalen Schaltungsteil 15 mit anderen Worten direkt oder auch über weitere Komponenten, die auch eine weitere Verarbeitung des Signals bedingen können, zugeführt werden.

Weiterhin sei angemerkt, dass beispielsweise zwischen dem analogen Filter 6 und dem analogen Addierer 7 sowie zwischen dem Addierer 7 und dem Begrenzer 11 jeweils ein Koppelkondensator K vorgesehen sein kann, was in Figur 2 entsprechend angedeutet ist. Das Paar von Koppelkondensatoren K dient der galvanischen Trennung bzw. bildet eine solche, die im Falle eines Phasenmodulationswandlers 1 sehr einfach und quasi an beliebiger Stelle in dem Signalpfad P bis zum digitalen Schaltungsteil 15 vorgesehen sein kann, was einen erheblichen Vorteil des Phasenmodulationswandlers 1 darstellt.

Das digitale Schaltungsteil 15 kann wenigstens einen FPGA und/oder ASIC umfassen oder durch wenigstens einen FPGA und/oder ASIC gegeben sein. Bei dem hier dargestellten Ausführungsbeispiel ist das digitale Schaltungsteil durch einen ASIC 15 gegeben. Bei dem ASIC 15 handelt es sich um einen Rückwandbus-ASIC 15 der SPS S.

Auf dem ASIC 15 ist eine Demodulationseinrichtung 16 der Vorrichtung 1 implementiert, mittels derer eine digitale Demodulation des begrenzten Signals $Sig_{BA}$ erfolgen kann. Die Demodulationseinrichtung 16 kann auch als digitaler Demodulator bezeichnet werden. Diese ist mit anderen Worten in den ohnehin vorhanden Rückwandbus-ASIC 15 der Steuerung S integriert, was sich als besonders vorteilhaft erwiesen hat.

Im Rahmen der Demodulation erfolgen unter anderem eine Abtastung des Signals $Sig_{BA}$ mittels wenigstens einem Abtast-Clocksignal CLK0-CLK3, ein Vergleich mit einem ebenfalls mit dem wenigstens einen Abtast-Clocksignal abgetasteten Referenzsignal $Sig_{RF}$ und eine Integration des Vergleichs. Auf die Erzeugung des Referenzsignals $Sig_{RF}$ und den Vergleich wird weiter unten noch näher eingegangen.

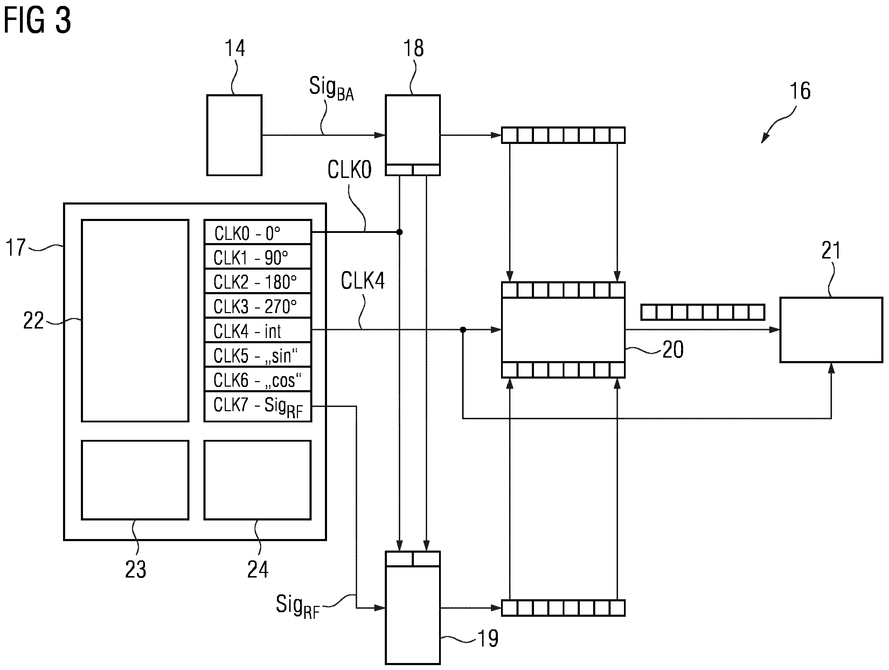

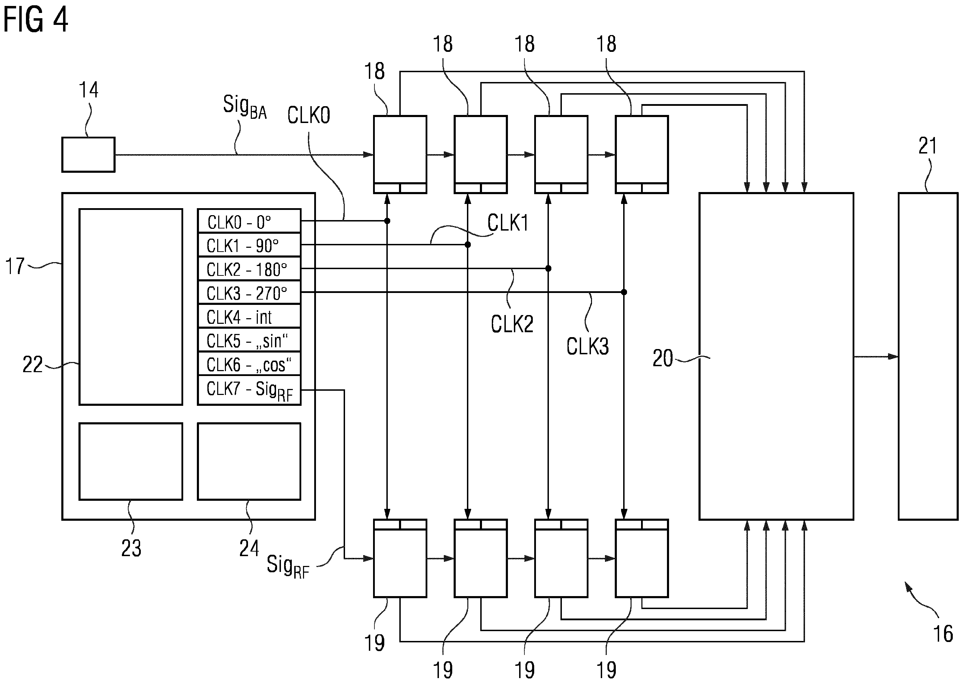

Die Figur 3 erhält eine rein schematische Blockdarstellung zu der digitalen Demodulation unter Verwendung der Demodulationseinrichtung 16 und zwar für den Fall, dass eine Abtastung mit einem Abtast-Clocksignal CLK0 erfolgt. Die Figur 4 zeigt eine alternatives Ausführungsbeispiel zur Nutzung mehrerer Abtast-Clocksignale für die Abtastung, hier beispielhaft von vier Abtast-Clocksignalen CLK0-CLK3.

Die Demodulationseinrichtung 16 umfasst eine Takterzeugungseinrichtung 17 und wenigstens einen Puffer 18 für das begrenzte Signal $Sig_{BA}$, der bevorzugt durch einen FIFO-Puffer gegeben ist, und vorliegend als Signal-Puffer 18 bezeichnet wird. Es ist ferner wenigstens ein weiterer Puffer 19 für das Referenzsignal $Sig_{RF}$ vorgesehen, der ebenfalls bevorzugt als FIFO-Puffer ausgebildet ist, und zur Unterscheidung gegenüber dem Puffer 18 für das Signal $Sig_{BA}$ als Referenz-Puffer 19 bezeichnet wird. Es sei angemerkt, dass trotz dieser verschiedenen Bezeichnungen der wenigstens eine Signal-Puffer 18 und der wenigstens eine Referenz-Puffer 19 baugleich ausgebildet sein können und vorliegend baugleich ausgebildet sind.

Die Anzahl der Signal-Puffer 18 und die Anzahl der Referenz-Puffer 19 stimmt zweckmäßiger Weise überein und entspricht jeweils der Anzahl der verwendeten Abtast-Clocksignale CLK0-CLK3. Die in Figur 3 gezeigte Demodulationseinrichtung 16 umfasst somit genau einen Signal-Puffer 18 und genau einen Referenz-Puffer 19,.

Die Figur 4 zeigt beispielhaft, dass vier Abtast-Clocksignale CLK0-CLK3 zur Abtastung des begrenzten Signals $Sig_{BA}$ und gleichzeitig des Referenzsignals $Sig_{RF}$ genutzt werden können. Die Demodulationseinrichtung 16 aus Figur 4 umfasst entsprechend vier, bevorzugt baugleiche, Signal-Puffer 18 und vier, bevorzugt baugleiche, Referenz-Puffer 19. In Figur 2 sind die Puffer 18, 19 aus Gründen der Übersichtlichkeit hintereinander dargestellt und der vorderste Puffer 18, 19 ist mit durchgezogener Linie gezeichnet, während die dahinterliegenden Puffer 18, 19 mit gestrichelter Linie dargestellt sind, um zu verdeutlichen, dass diese optional zusätzlich vorhanden sein können.

Den Puffern 18, 19 nachgeschaltet und mit den Ausgängen der Puffer 18, 19 verbunden ist ein XOR-Modul 20, welches ein XOR-Gatter umfassen oder durch ein solches gegeben sein kann. Konkret gilt, dass der Ausgang des wenigstens einen Signal-Puffers 18 mit einem Eingang des XOR-Moduls 20 und der Ausgang des wenigstens einen Referenz-Puffers 19 mit dem anderen Eingang des XOR-Moduls 20 verbunden ist, so dass ausgegebene Werte an dieses übergeben und verglichen werden können. Bei dem Ausführungsbeispiel aus Figur 4 sind die Ausgänge aller vier Signal-Puffer 18 mit dem einen Eingang des XOR-Moduls 20 und die Ausgänge aller vier Referenz-Puffer 19 mit dem anderen Eingang des XOR-Moduls 20 verbunden.

Darüber hinaus ist ein dem XOR-Modul 20 nachgeschalteter Integrator 21 vorhanden, mittels dem von dem XOR-Modul 20 ausgegebene Werte integriert werden können.

Bei dem in den Figuren 3 und 4 dargestellten Ausführungsbeispiel umfasst die Takterzeugungseinrichtung 17 der Demodulationseinrichtung 16 insgesamt drei Taktblöcke 22, 23, 24. Mittels dieser drei Taktblöcke 22, 23, 24 werden insgesamt sieben Clocksignale CLK0-CLK7 erzeugt, auch die für die Abtastung genutzten Abtast-Clocksignale CLK0 (Fig. 3) bzw. CLKO-CLK3 (Fig. 4). Es sei angemerkt, dass die Taktblöcke 22, 23, 24 auch als Taktmodule bezeichnet werden können.

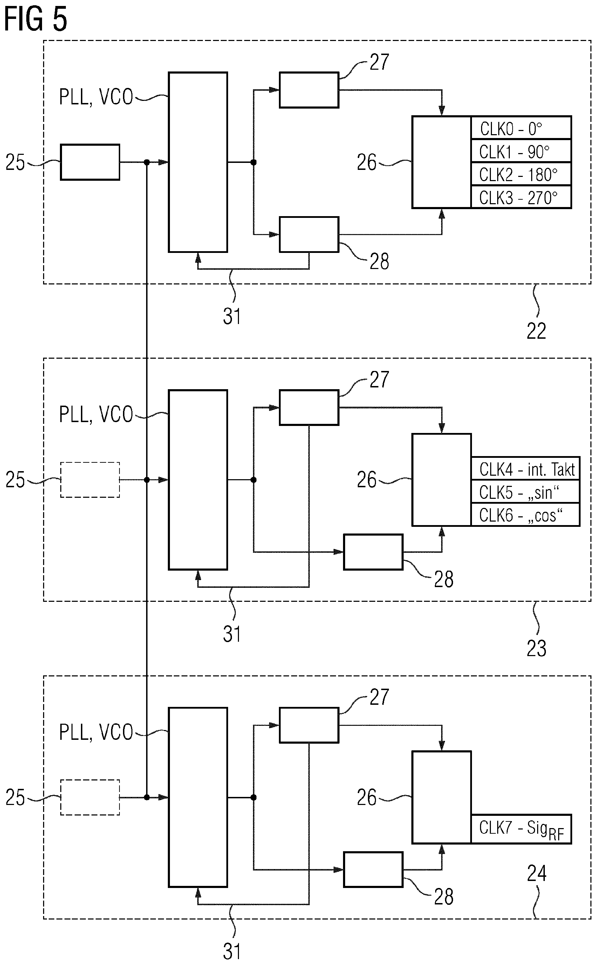

Jeder der Taktblöcke 22-24 umfasst dabei eine Phasenregelschleife PLL mit einem spannungsgesteuerten Oszillator VCO. Der interne Aufbau der drei Taktblöcke 22 bis 24 ist - wiederum stark vereinfacht und rein schematisch - in der Figur 5 gezeigt. Hier sind die Phasenregelschleife PLL mit dem spannungsgesteuerten, internen Oszillator VCO des jeweiligen Taktblocks 22-24 vereinfacht als ein Blockelement dargestellt.

Der interne Oszillator VCO jedes Taktblocks 22-24 wird auf ein externes Referenzsignal von einer externen Taktquelle 25, die beispielsweise durch einen Quarzresonator gegeben sein kann, mit einem entsprechend eingestellten Faktor auf eine höhere innere Frequenz fvco ausgeregelt. Die drei Taktblöcke 22-24 können von der gleichen externen Taktquelle 25 versorgt werden, was jedoch nicht zwingend der Fall sein muss.

Die Taktblöcke 22-24 können zum Beispiel jeweils durch ein Mixed-Mode Clock-Manager (kurz MMCM) Modul bzw. Block gegeben sein oder ein solches bzw. einen solchen umfassen. Die Hersteller Xilinx bzw. AMD beispielsweise bieten FPGAs mit solchen Modulen bzw. Blöcken an. Weiter beispielhaft seien FPGAs von Lattice Semiconductor genannt, insbesondere der Serie EPS, ECP5, EPC5-5G, die ebenfalls eine feine Unterteilung der Phase und zwar mit bis zu 300 Schritten ermöglichen.

Jeder der Taktblöcke 22 bis 24 hat mehrere Clockausgänge, die in der Figur 5 durch ein mit der Bezugsziffer 26 versehenes Blockelement angedeutet sind. Jeder Clockausgang kann verschiedene Teiler - und somit Frequenzen - und verschieden fest definierte Phasenlagen annehmen. Alle Takte werden dabei aus fvco abgeleitet. Neben dem die Clockausgänge repräsentierenden Blockelement 26 stehen die von dem jeweiligen Taktblock 22-24 in dem gezeigten Ausführungsbeispiel erzeugten und ausgegebenen Abtast-Clocksignale CLK0-CLK7. Die entsprechende Nummerierung CLK0 bis CLK7 findet sich auch in den Figuren 3 und 4, dies nebst Pfeilen zu deren konkreter Nutzung, worauf noch eingegangen wird. Jeder Taktblock 22-24 bzw. dessen Oszillator VCO hat sowohl phasenstarre Abgriffe 27 als auch wenigstens einen phasenvariable Abgriff 28. Der phasenvariable Abgriff 28 ermöglicht eine Unterteilung der Phasenlage in feine Schritte. Bei den hier dargestellten Ausführungsformen kann eine Unterteilung in 56 Schritte erfolgen, mit anderen Worten in Schritte von 360°/n mit n = 56. Die Anzahl von 56 Schritte ist dabei beispielhaft zu verstehen.

Der Taktblock 22 kommt zum Einsatz, um die schnellen Abtasttakte, mit anderen Worten Abtast-Clocksignale, für die Abtastung sowohl des begrenzten Signals $Sig_{BA}$, als auch des Referenzsignales $Sig_{RF}$ bereitzustellen. Bei dem Beispiel gemäß Figur 3 handelt es sich um das Abtast-Clocksignal CLK0, bei demjenigen gemäß Figur 4 um die Abtast-Clocksignale CLKO-CLK3.

Rein beispielshaft für eine Frequenz der für die Abtastung genutzten schnellen Abtast-Clocksignale CLK0-CLK3, die aus fvco abgeleitet wird, sei 256 MHz genannt. $f_{VCO}$ kann beispielsweise 1024 MHz betragen. Selbstverständlich sind auch andere Frequenzen möglich. Zweckmäßiger Weise gilt, dass die Frequenz des (jeweiligen) Abtast-Clocksignals CLKO-CLK3 um wenigstens eine Größenordnung, bevorzugt um zwei Größenordnungen, über der Modulatorfrequenz des Amplitudenmodulators 2 liegt.

Der zweite Taktblock 23 dient der Erzeugung von langsamen internen Signalen. Dieser erzeugt bei dem dargestellten Ausführungsbeispiel die Clocksignale CLK4, CLK5 und CLK6. CLK4 ist ein langsamerer interner Takt, der vorliegend 32 MHz beträgt, was wiederum beispielhaft zu verstehen ist, und der für die Puffer 18, 19 sowie das XOR-Modul 20 und den Integrator 21 genutzt wird, was in der Figur 3 durch entsprechende Pfeile angedeutet ist. CLK5 entspricht einem Rechteck- oder Sinussignal. CLK6 einem um 90° zu dem Rechteck- bzw. Sinussignal versetzten Signal, also insbesondere einem Cosinussignal. Das Rechteck- bzw. Sinussignal wird über einen Ausgang 29 des ASICs 15 in Richtung des Addierers 7 ausgeben, um $Sig_{T90}$ zu erhalten und dem Eingang 9 des Addierers 7 zuzuführen. Über einen Ausgang 30 des ASICs 15 wird das Cosinussignal als $Sig_T$ in Richtung des Amplitudenmodulators 2, konkret dessen Eingang 4, ausgegeben. Es sei angemerkt, dass sich zwischen dem Ausgang 29 des ASICs 15 und dem Eingang 9 des Addierers 7 noch ein analoger Filter 6 befindet. Zwischen dem Ausgang 30 des ASICs 15 und dem Eingang 4 des Amplitudenmodulators 2 ist eine solcher hingegen nicht eingezeichnet, wenngleich auch nicht ausgeschlossen ist, dass sich hier ebenfalls ein solcher befindet.

Der dritte Taktblock 24 dient der Erzeugung von CLK7, was dem Referenzsignal $Sig_{RF}$ entspricht bzw. zu dessen Erzeugung genutzt wird. Es handelt sich um ein rein internes Signal, welches den ASIC 15 nicht verlässt.

Die drei Taktblöcke 22-24 können von ihrem Aufbau her im Wesentlichen übereinstimmen. Ein Unterschied zwischen dem Taktblock 22 und den Blöcken 23 und 24 besteht jedoch darin, dass der Rückkoppelpfad 31 der Phasenregelschleife PLL bzw. von deren Oszillator VCO mit dem phasenvariablen Abgriff 28 des Oszillators VCO verbunden ist, während bei den Taktmodulen 23 und 24 der Rückkoppelpfad 31 mit einem phasenstarren Abgriff 27 verbunden ist (vgl. Figur 5).

Im Betrieb der Vorrichtung dient im Falle von Fig. 3 der eine Signal-Puffer 18 zur Abtastung des begrenzten Signals $Sig_{BA}$ mit dem schnellen Abtast-Clocksignal CLK0 bzw. dienen im Falle von Fig. 4 die vier Signal-Puffer 18 der Abtastung des begrenzten Signals $Sig_{BA}$ mit den vier fest zueinander phasenversetzten schnellen Abtast-Clocksignalen CLK0-CLK3 sowie der Einsynchronisierung auf die langsamere interne Clockdomäne. Dem (jeweiligen) Signal-Puffer 18 wird eingangsseitig das begrenzte Signal $Sig_{BA}$ zur Abtastung zugeführt. Der (jeweilige) Signal-Puffer 18 erhält sowohl eines der schnellen Abtast-Clocksignale CLK0-CLK3 zur Abtastung, dies von dem Taktblock 22, als auch das langsamere interne Clocksignal CLK4, auf welches mittels des (jeweiligen) Signal-Puffers 18 einsynchronisiert wird, dies von dem Taktblock 23. Es sei angemerkt, dass in der Figur 4 zur Nutzung der mehreren Clocksignale CLK0-CLK3 und zugehöriger Puffer 18, 19 die Pfeile zu dem langsameren internen Takt CLK4 aus Gründen der Übersichtlichkeit nicht zusätzlich eingezeichnet sind.

Der (jeweilige) Signal-Puffer 18 hat einen Eingang mit einer Bitbreite von 1 und einen Ausgang mit einer Bitbreite von 8. Das Verhältnis der Bitbreiten vom Eingang zum Ausgang des (jeweiligen) Signal-Puffers 18 wird analog zum Verhältnis der Takte CLKi/CLK4, mit i = 0, 1, 2, 3, gewählt oder umgekehrt. Bei dem hier beschriebenen Beispiel gilt die CLKi/CLK4 = 256 MHz/32 MHz = 8, mit i = 0, 1, 2, 3.

Immer, wenn 8 Abtastwerte in einem Signal-Puffer 18 "aufgelaufen" sind, werden diese mehreren Werte von dem Signal-Puffer 18 ausgegeben und zwar an das XOR-Modul 20. Die Ausgabe erfolgt mit dem langsameren Takt von CLK4, also vorliegend 32 MHz. Man kann auch sagen, der (jeweilige) Signal-Puffer 18 liefert als Ausgang das "abgesamplete" digitale begrenzte Signal $Sig_{BA}$ in zeitlich richtiger Reihenfolge.

Für den (jeweiligen) Referenz-Puffer 19 gilt das vorstehende völlig analog mit dem Unterschied, dass diesen nicht das begrenzte Signal $Sig_{BA}$, sondern das Referenzsignal $Sig_{RF}$ zur Abtastung mit dem (jeweiligen) schnellen Abtast-Clocksignal CLK0-CLK3 und zur Einsynchronisierung auf CLK4 zugeführt wird, wie in den Figuren 3 und 4 schematisch durch zugehörige Pfeile angedeutet.

Von dem (jeweiligen) Referenz-Puffer 19 wird somit das "abgesamplete" digitale Referenzsignal erhalten, welches mit gleichem Clocksignal CLK0 bzw. mit gleichen Clocksignalen CLK0-CLK3 eingetaktet ist. Damit passt die zeitliche Reihenfolge zum "abgesampleten" begrenzten $Sig_{BA}$ Signal, das von dem oder den Signal-Puffern 18 erhalten wird.

Bei der Variante gemäß Figur 4 mit den vier Abtast-Clocksignalen CLK0-CLK3 gibt dabei jeder Signal-Puffer 18 einen anderen Teil des Signals aus. Jede CLK.Abtastdomäne liefert einen Datenblock. In der gleichen Domäne wird passend dazu das Referenzsignals $Sig_{RF}$ "abgetastet". Im XOR-Modul 20 ist dann ein Vergleich "Blockweise" möglich.

Zur Erzielung einer erhöhten Auflösung kann im Rahmend der Abtastung optional vorgesehen sein, dass die Phasenlage des einen Abtast-Clocksignals CLK0 (Figur 3) bzw. der mehreren Abtast-Clocksignale CLK0-CLK3 (Figur 4), die für die Abtastung des begrenzten Signals $Sig_{BA}$ und des Referenzsignals $Sig_{RF}$ genutzt werden, dynamisch geändert wird. Der Rückkoppelpfad 31 des Taktblockes 22 für die Erzeugung der schnellen Clocksignale CLKO-CLK3 ist hierfür, wie oben erwähnt, mit dem phasenvariablen Abgriff 28 des Oszillators VCO verbunden.

Es wird kontinuierlich bzw. wiederholend die Phasenlage des über den Rückkoppelpfad 31 dem Oszillator VCO rückgeführten Signals geändert. Dies erfolgt bevorzugt zyklisch beispielsweise alle paar Mikrosekunden, etwa alle 42 Mikrosekunden. Die Verschiebung der Phasenlage erfolgt dabei jeweils um Schritte von 360°/56 und in die gleiche Richtung. Es ist eine Logik 32 vorgesehen (vgl. Figur 2), welche bevorzugt auf dem ASIC 15 implementiert ist, welcher auch die Demodulationseinrichtung 16 umfasst oder bildet, und welche die entsprechende Steuerung für die dynamische Phasenlagenänderung der Abtast-Clocksignale umsetzt. Die Logik 32 kann Bestandteil der Demodulationseinrichtung 16 sein.

Da bei dem Ausführungsbeispiel gemäß Figur 4 die mehreren Abtast-Clocksignale CLKO-CLK3 alle aus dem Ausgangssignal des einen Oszillators VCO des Taktblocks 22 erzeugt werden, resultiert die wiederholte Änderung der Phasenlage des Rückkoppelsignals in eine wiederholte Änderung der Phasenlagen aller für die Abtastung genutzter Abtast-Clocksignale CLK0-CLK3 synchron und um gleich große Schritte.

Durch das Stepping des Feedbacksignals über den Rückkoppelpfad 31 ändert sich mit die Phasenlage aller CLK-Ausgänge des Taktmoduls 22 synchron zu jedem Phasenschritt des Oszillators VCO. Die einzelnen Abtast-Clocksignale CLK0-CLK3 können zusätzlich weiterhin starr um 90° zueinander versetzt sein.

Im beschriebenen Fall entspricht ein Phasenschritt von

$$t_{STEP} = 1/(768MHz*56) = 1/43,008GHz = 23,25ps.$$

Durch die 90° zueinander versetzten 256MHz Abtasttakte CLK0-CLK3 muss nur eine Phasendifferenz von

$$t_{diff} = 1/(256MHz*4) = 976,56ps$$

überbrückt werden, um alle möglichen diskreten Abtastpunkte mittels des feinschrittingen Phasensteppings abzudecken. Im ASIC 15 werden 42 (976,56ps/23,25ps) Perioden der Modulatorfrequenz aufsummiert.

Die rechnerische Auflösung ergibt sich zu

$$log2(90°/360° * 43008MHz / 1MHz) = 13,39 \text{ Bit}$$

ohne die Frequenz des Amplitudenmodulators 2 zu ändern.

Die Datenrate reduziert sich von 1MHz auf 1MHz/42 = 23,8kHz.

Ohne die dynamische Phasenverschiebung ergäbe sich hingegen eine rechnerische Auflösung von

$$log2(90°/360° * 4*256MHz / 1MHz) = 8 \text{ Bit.}$$

Wie vorstehend betont, ist die Auflösungserhöhung durch die dynamische Phasenverschiebung optional. Insbesondere für den Fall, dass einer oder mehrere digitale Eingänge bereitgestellt werden, kann in der Regel auch eine niedrigere Auflösung ausreichen. Entsprechend kann auch die Modulatorfrequenz des Amplitudenmodulators 2 erhöht werden. Damit steigt zum einen die Datenrate und zum anderen können Filterelemente nochmals wesentlich kleiner werden.

Es wäre auch denkbar, integrierte Filter, wie sie z.B. im RFID / ISM Bereich in hohen Stückzahlen genutzt werden, einzusetzen. Beispielhaft seien Filter für Frequenzen von 13,56 MHz oder 27 MHz oder 40 MHz oder 433 MHz genannt.

Bei gleicher Architektur würde sich trotzdem noch eine Auflösung von

$$log2(90°/360° * 43008MHz / 13,56MHz) = 9,6 \text{ Bit (RFID Frequenz)}$$

bzw. eine Auflösung von

$$log2(90°/360° * 43008MHz / 315MHz) = 5,09 \text{ Bit (SAW Filter für ISM Band)}$$

ergeben was zur Ermittlung insbesondere eines digitalen Zustandes noch immer ausreicht.

Mittels des den Puffern 18, 19 nachgeschalteten XOR-Moduls 20 wird im Anschluss an die schnelle Abtastung (mit oder ohne dynamischer Phasenverschiebung) und der Einsynchronisierung festgestellt, zu welchen Zeitpunkten das begrenztes Signal $Sig_{BA}$ und das Referenzsignal $Sig_{RF}$ unterschiedlich sind. Die anschließende Integration mittels des Integrators 21 ergibt den gewandelten Wert, der als Sigo von dem ASIC 15 ausgegeben bzw. zunächst noch weiterverarbeitet wird (vgl. Fig. 2).

Zweckmäßiger Weise wird jeweils so lange integriert, bis die vorstehend beschriebene dynamische Änderung der Phasenlage der Abtast-Clocksignale CLK0-CLK3 über einen Winkelbereich von 360°/m erfolgte, wobei m der Anzahl der für die Abtastung von dem begrenztem Signal $Sig_{BA}$ genutzten Abtast-Clocksignale entspricht. Die erfindungsgemäße Vorrichtung 1, insbesondere deren Demodulationseinrichtung 16 bzw. ein FPGA 15 der Vorrichtung, kann entsprechend eingerichtet sein.

Insbesondere für den Fall, dass keine dynamische Änderung der Phasenlagen des bzw. der Abtast-Clocksignale CLK0-CLK3 erfolgt, gilt zweckmäßiger Weise, dass ich mit jeder Periode ein neuer, gewandelter Digitalwert ergibt.

Sigo ist insbesondere ein digitales Signal bzw. digitaler Wert im Wertebereich von zum Beispiel 0 bis $2^a$ mit der Auflösung a des Phasenmodulationswandlers P. Dieser digitale Wert kann weitergegeben bzw. weiterverarbeitet und einer Nutzung zugeführt werden. Es kann beispielsweise für den Fall eines "digitalen Eingangs" vorgesehen sein, dass ein Vergleich gegen einen Schwellwert erfolgt und dann pro Kanal C1, C2, ..., Cn nur 1 Bit (0/1) weitergegeben wird, um die Datenmenge möglichst gering zu halten.

Es sei angemerkt dass bevorzugt gilt, dass unabhängig davon, ob das Eingangssignal $Sig_A$ an der eingangsseitigen Anschlussstelle I, etwa SPS-Klemme, analog oder digital ist, dieses insbesondere bis zu der Demodulationseinrichtung 16 bzw. bis durch die Demodulationseinrichtung 16 hindurch als analoger Wert betrachtet wird. Erst bei der Interpretation des Wertes kann eine (übergeordnete) Logik dann entscheiden, ob das Signal nun digital ist oder auf analoge Weise, insbesondere eine Prozessgröße, beschriebt.

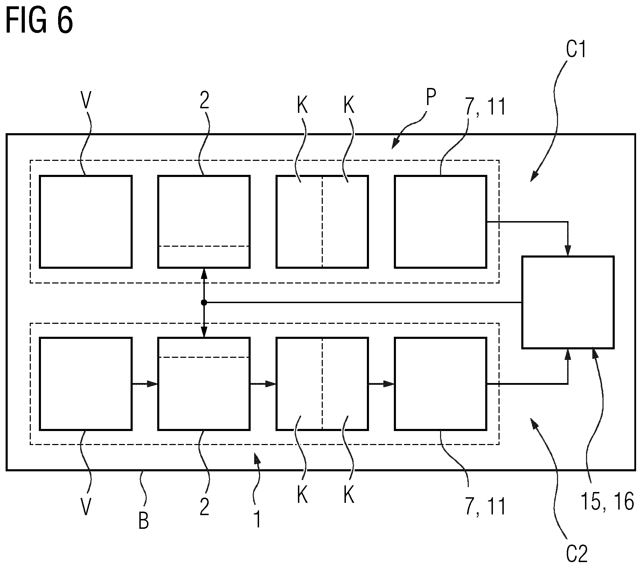

Die Figur 6 zeigt in rein schematischer Darstellung ein weiteres Ausführungsbeispiel einer erfindungsgemäßen Eingangseinrichtung in Form einer Eingangsbaugruppe B. Diese kann ebenfalls Bestandteil einer nicht weiter dargestellten speicherprogrammierbaren Steuerung oder auch einer Messvorrichtung sein. Das Beispiel gemäß Figur 6 ist dabei mehrkanalig, konkret zweikanalig ausgebildet. Hierfür umfasst es eine Eingangsschaltung 1 mit einem mehrkanaligen Phasenmodulationswandler P. Es sei angemerkt, dass die Figur 6 den grundsätzlichen Aufbau einer mehrkanaligen Konfiguration aufzeigen soll, wobei aus Gründen der Übersichtlichkeit nur einige der Komponenten der Eingangsschaltung 1 und deren Phasenmodulationswandlers P dargestellt sind, dies teilweise noch vereinfachter, als in Figur 1.

Wie man erkennt, ist für jeden der beiden Kanäle C1, C2 ein eigenes Signalverarbeitungsmodul V vorhanden. Auch sind für jeden Kanal C1, C2 ein eigener Amplitudenmodulator 2, wenigstens eine galvanische Trennung mit zwei Koppelkondensatoren K, sowie ein eigener Addierer 7 und Begrenzer 11 vorgesehen. Diese Komponenten skalieren mit anderen Worten mit der Anzahl der Kanäle C1, C2.

Demgegenüber umfasst der Phasenmodulationswandler 2 trotz der mehrkanaligen Ausgestaltung nur eine zentrale Demodulationseinrichtung 16, die bevorzugt auf einem FPGA oder ASIC 15 implementiert ist. Die Begrenzer 11 der mehreren, hier zwei, Kanäle C1, C2 sind dabei mit der zentralen Demodulationseinrichtung 16 verbunden, so dass der zentralen Demodulationseinrichtung 16 von den mehreren Begrenzern 11 jeweils ausgegebene Signale $Sig_{BA}$ zugeführt werden und darin jeweils mit wenigstens einem Abtast-Clocksignal CLKO-CLK3 abgetastet werden können. Die Verbindung ist eine signaltechnische Verbindung. Die mehreren Begrenzer 11 können direkt oder auch über weitere Elemente mit der zentralen Demodulationseinrichtung 16 verbunden sein.

Im Vergleich zu der Realisierung eines konventionellen ADCs auf der Prozessseite hat der Phasenmodulationswandler 2 den weiteren Vorteil, dass nicht ein separater kompletter Wandler pro Kanal C1,C2 aufgebaut werden muss. Es muss auch nicht die komplette Erzeugung der für den Wandler notwendigen Versorgungsspannungen, Referenzen und deren Filter pro Kanal erfolge, was häufig "teurer" als der eigentliche Wandler ist, dies sowohl in Bezug auf Kosten als auch dem Platz auf der Leiterplatte. Die vorliegende Lösung kann demgegenüber deutlich schlanker und kostengünstiger ausfallen. Insbesondere ist auch nicht für jeden Kanal ein eigener FPGA bzw. ASIC 15 erforderlich.

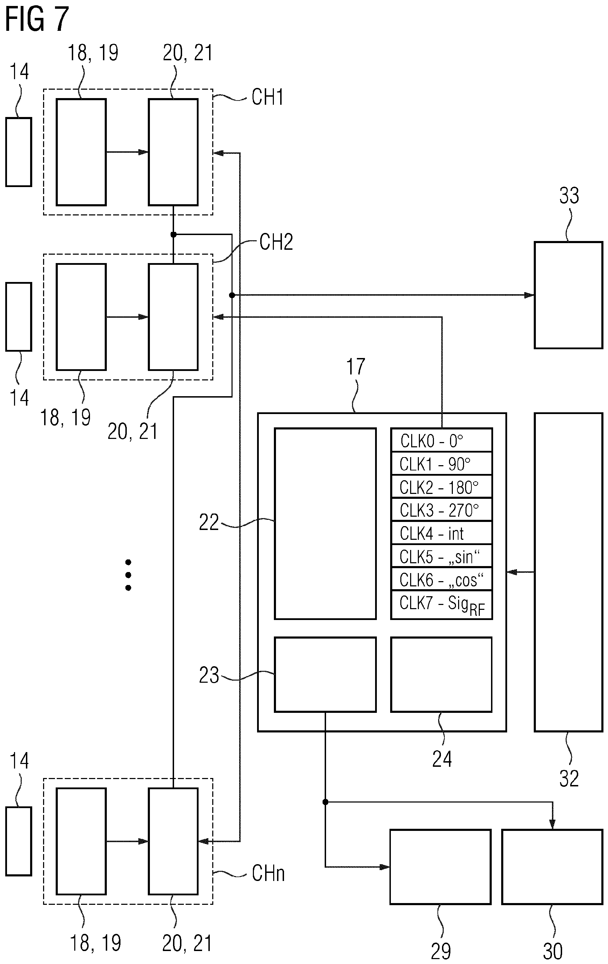

Eine Skalierung innerhalb des einen ASICs 15 (oder alternativ eines FPGAs) auf die mehreren Kanäle C1, C2, ..., Cn kann vorgesehen sein. Dies ist - rein schematisch - in der Figur 7 dargestellt.

Auf dem ASIC 15 ist dabei für jeden Kanal C1, C2, ...Cn ein ASIC-Eingang 14 vorgesehen, sowie eigene Puffer 18, 19, ein eigenes XOR-Modul 20 und ein eigener Integrator 21. Die Funktionsweise ist hier für jeden Kanal C1, C2, ..., Cn, wie oben im Zusammenhang mit Figur 3 für die Nutzung eines Abtast-Clocksignals CLK0 und im Zusammenhang mit Figur 4 für die Nutzung von vier Abtast-Clocksignalen CLK0-CLK3 für den Fall nur eines Kanals ausführlich beschrieben.

Die genannten, auf die mehreren Kanäle C1, C2, ..., Cn "hochskalierten" Komponenten sind dabei mit einer zentralen Takterzeugungseinrichtung 17 verbunden. Diese kann, wie vorstehend unter Bezug auf die Figuren 2 bis 5 bereits beschrieben, beispielsweise drei Takterzeugungsmodule 22, 23, 24 umfassen, mittels denen Clocksignale CLK0-CLK7 erzeugt werden können, die dann für alle Kanäle C1, C2, ..., Cn genutzt werden. Dies ist in der Figur 7 durch Pfeile angedeutet, welche die zentrale Takterzeugungseinrichtung 17 mit den für die Kanäle C1, C2, ..., Cn mehrfach vorhandenen Komponenten, insbesondere den Puffern 18, 19 und Integratoren 21, verbinden.

Die von den Integratoren 21 ausgegebene Werte können beispielsweise an eine auf dem ASIC 15 vorgesehene Abgreif- und Aufbereitungslogik 33 übergeben werden, welche diese abgreift und aufbereitet, etwa für eine höhere Logik (nicht dargestellt).

Wie man in der Figur 6 erkennt, ist der ASIC 15 bzw. die darauf implementierte Demodulationseinrichtung 16 mit den Amplitudenmodulatoren 2 der mehreren Kanäle C1, C2 verbunden. Die die Eingangsbaugruppe B ist dabei derart ausgebildet und/oder eingerichtet, dass die Amplitudenmodulatoren 2 der mehreren Kanäle C1, C2 mittels der zentralen Demodulationseinrichtung 16 getaktet werden können, und/oder dass den Amplitudenmodulatoren 2 der mehreren Kanäle C1, C2 wenigstens ein von der zentralen Demodulationseinrichtung 16 erzeugtes Trägersignal zugeführt werden kann.

Konkret ist der auch in Figur 7 erkennbare Ausgang 30 mit jedem der Amplitudenmodulatoren 2 der mehreren Kanäle C1, C2 verbunden und zwar jeweils mit deren Eingang 4 (vgl. Figur 1). Durch diese Ausgestaltung wird eine "gating" Funktion, wie es beim taktsynchronen Einlesen von Eingänge, insbesondere digitalen Eingängen, oftmals nötig ist bereits implizit realisiert.

Da alle Kanäle C1, C2, ..., Cn aus der gleichen Referenz-Clock abgeleitet werden, ergibt sich automatisch ein taktsynchroner Betrieb. Einzig die Laufzeiten und die Reaktionszeiten der Schaltermodulatoren 2 können von Kanal zu Kanal C1, C2, ..., Cn noch variieren.

Bei einem Phasenmodulationswandler P erfolgt keine Übertragung von "1 und 0", sondern eine analoge Abtastung insbesondere vom begrenzten Signal $Sig_{BA}$. Dies auch in demjenigen Falle, dass ein Phasenmodulationswandler P für einen digitalen Eingang genutzt wird, mit anderen Worten für digitale Signale. Im analogen Bereich ist es möglich, neben den beiden Zuständen "1 und 0" noch Zusätzliches mit abzudecken, insbesondere einen dritten Zustand. Dies kann genutzt werden, um zusammen mit dem eigentlichen Signalzustand Diagnoseinformationen, etwa eine Information über einen Draht- bzw., Leitungsbruch, zu übertragen, dies ohne dass es hierfür eines zusätzlichen Kanals C1, C2, ..., Cn bedarf. Das Eingangssignal $Sig_A$ kann mit anderen Worten neben der eigentlichen Signalinformation eine Diagnoseinformation umfassen, die über den gleichen Kanal C1, C2, ..., Cn mit übertragen werden kann.

Durch die mit der Nutzung des Phasenmodulationswandlers P einhergehenden Übertragung der Information über die Potentialtrennung K im Frequenzbereich ergibt sich ferner ein deutlicher Vorteil bezüglich der EMV-Festigkeit. Common Mode Störungen werden durch die AC-Koppelkondensatoren K unterdrückt. Es besteht nur eine Sensibilität bezüglich der Unsymmetrie. Eine Filterung kann hier aber einfach mittels Low-Voltage Kondensatoren auf der Logikseite erfolgen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Unabhängig vom grammatikalischen Geschlecht eines bestimmten Begriffes sind Personen mit männlicher, weiblicher oder anderer Geschlechteridentität mit umfasst.

**Patentansprüche**

1. Eingangseinrichtung (B), insbesondere Eingangsbaugruppe, für eine bevorzugt speicherprogrammierbare Steuerung (S) oder für eine Messevorrichtung, insbesondere ein Oszilloskop oder ein bevorzugt digitales Multimeter, wobei die Eingangseinrichtung (B) wenigstens eine Eingangsschaltung (1) umfasst, um wenigstens einen digitalen oder wenigstens einen analogen Eingang für eine Steuerung (S) oder Messvorrichtung bereitzustellen, **dadurch gekennzeichnet, dass**

    die wenigstens eine Eingangsschaltung (1) wenigstens einen Phasenmodulationswandler (P) umfasst, wobei der wenigstens eine Phasenmodulationswandler (P) aufweist:

    - einem Amplitudenmodulator (2) mit Trägerunterdrückung, dem ein Eingangssignal ($Sig_A$) eingangsseitig zugeführt werden kann, um ein trägerloses amplitudenmoduliertes Signal ($Sig_{AM}$) zu erhalten,
    - einem Addierer (7), um zu dem trägerlosen amplitudenmodulierten Signal ($Sig_{AM}$) ein um 90° verschobenes, bevorzugt sinusförmiges Trägersignal ($Sig_{T90}$) zu addieren und ein phasenmoduliertes Signal ($Sig_{PM}$) zu erhalten,
    - einem Begrenzer (11), dem das phasenmodulierte Signal ($Sig_{PM}$) zugeführt werden und mit dem eine Störamplitudenmodulation in dem phasenmodulierten Signal ($Sig_{PM}$) unterdrückt werden kann, und
    - einer Demodulationseinrichtung (16), der das von dem Begrenzer (11) ausgegebene Signal ($Sig_{BA}$) zugeführt und darin mit wenigstens einem Abtast-Clocksignal (CLKO-CLK3) abgetastet werden kann.

2. Eingangseinrichtung (B) nach Anspruch 1,
    **dadurch gekennzeichnet, dass**
    zwischen dem Amplitudenmodulator (2) und der Demodulationseinrichtung (16) des wenigstens einen Phasenmodulationswandlers (P) wenigstens eine galvanische Trennung vorgesehen ist, insbesondere, wobei die wenigstens eine galvanische Trennung wenigstens ein Paar von Koppelkondensatoren (K) umfasst.

3. Eingangseinrichtung (B) nach Anspruch 1 oder 2,
**dadurch gekennzeichnet, dass**

der wenigstens eine Phasenmodulationswandler (P) mehrkanalig ausgebildet ist, um mehrere Eingänge bereitzustellen, bevorzugt, wobei der wenigstens eine mehrkanalige Phasenmodulationswandler (P) eine zentrale Demodulationseinrichtung (16) und für jeden Kanal (C1, C2, ..., Cn) einen eigenen Amplitudenmodulator (2), einen eigenen Addierer (7) und einen eigenen Begrenzer (11) umfasst, wobei die Begrenzer (11) der mehreren Kanäle (C1, C2, ..., Cn) mit der zentralen Demodulationseinrichtung (16) verbunden sind, so dass der zentralen Demodulationseinrichtung (16) von den mehreren Begrenzern (C1, C2, ..., Cn) jeweils ausgegebene Signale zugeführt werden und darin mit wenigstens einem Abtast-Clocksignal (CLK0-CLK3) abgetastet werden können.

4. Eingangseinrichtung (B) nach Anspruch 3,
**dadurch gekennzeichnet, dass**

die Amplitudenmodulatoren (2) der mehreren Kanäle (C1, C2, ..., Cn) mit der zentralen Demodulationseinrichtung (16) verbunden sind, insbesondere, wobei die Eingangseinrichtung (B) derart ausgebildet und/oder eingerichtet ist, dass die Amplitudenmodulatoren (2) der mehreren Kanäle (C1, C2, ..., Cn) mittels der zentralen Demodulationseinrichtung (16) getaktet werden können, und/oder dass den Amplitudenmodulatoren (2) der mehreren Kanäle (C1, C2, ..., Cn) wenigstens ein von der zentralen Demodulationseinrichtung (16) erzeugtes Trägersignal ($Sig_T$) zugeführt werden kann.

5. Eingangseinrichtung (B) nach einem der vorhergehenden Ansprüche,
**dadurch gekennzeichnet, dass**
die Eingangseinrichtung (B) mehrere Eingangsschaltungen (1) aufweist, um mehrere Eingänge bereitzustellen.

6. Eingangseinrichtung (B) nach Anspruch 5,
**dadurch gekennzeichnet, dass**
jede Eingangsschaltung (1) wenigstens einen Phasenmodulationswandler (P) umfasst.

7. Eingangseinrichtung (B) nach einem der vorhergehenden Ansprüche,
**dadurch gekennzeichnet, dass**
die Demodulationseinrichtung (16) des wenigstens einen Phasenmodulationswandlers (P) auf wenigstens einem FPGA und/oder auf wenigstens einem ASIC (15) implementiert ist.

8. Eingangseinrichtung (B) nach Anspruch 7,
**dadurch gekennzeichnet, dass**
die Eingangseinrichtung (16) als insbesondere speicherprogrammierbare Steuerung (S) ausgebildet ist, und die Demodulationseinrichtung (16) des wenigstens einen Phasenmodulationswandlers (P) auf einem Rückwandbus-ASIC (15) der Steuerung (S) implementiert ist.

9. Eingangseinrichtung (B) nach einem der vorhergehenden Ansprüche,
**dadurch gekennzeichnet, dass**
die wenigstens eine Eingangsschaltung (1) ein Signalverarbeitungsmodul (V) umfasst, und der wenigstens einen Phasenmodulationswandler (P) dem wenigstens einen Signalverarbeitungsmodul (V) nachgeschaltet ist, bevorzugt, wobei das wenigstens eine Signalverarbeitungsmodul (V) wenigstens einen Widerstand und/oder wenigstens eine Diode, insbesondere Zener-Diode, und/oder wenigstens einen Transistor umfasst.

10. Eingangseinrichtung (B) nach einem der vorhergehenden Ansprüche,
**dadurch gekennzeichnet, dass**
die Eingangseinrichtung (B) wenigstens einen Filter (6) aufweist, der für eine Frequenz von 13,56 MHz oder 27 MHz oder 40 MHz oder 433 MHz ausgebildet ist, bevorzugt, wobei der wenigstens eine Phasenmodulationswandler (P) der Eingangseinrichtung (1) wenigstens einen Filter aufweist, der für eine Frequenz von 13,56 MHz oder 27 MHz oder 40 MHz oder 433 MHz ausgebildet ist.

11. Steuerung (S), insbesondere speicherprogrammierbare Steuerung, umfassend wenigstens eine Eingangseinrichtung (B) nach einem der vorhergehenden Ansprüche.

12. Messvorrichtung, insbesondere Oszilloskop oder bevorzugt digitales Multimeter, umfassend wenigstens eine Eingangseinrichtung nach einem der Ansprüche 1 bis 10.

**13.** Verwendung einer Eingangseinrichtung (B) nach einem der Ansprüche 1 bis 10 in einer insbesondere speicherprogrammierbaren Steuerung (S) oder einer Messvorrichtung, insbesondere einem Oszilloskop oder bevorzugt digitalen Multimeter.

**14.** Verwendung eines Phasenmodulationswandlers (P), umfassend

- einen Amplitudenmodulator (2) mit Trägerunterdrückung, dem ein Eingangssignal ($Sig_A$) eingangsseitig zugeführt werden kann, um ein trägerloses amplitudenmoduliertes Signal ($Sig_{AM}$) zu erhalten,
- einen Addierer (7), um zu dem trägerlosen amplitudenmodulierten Signal ($Sig_{AM}$) ein um 90° verschobenes, bevorzugt sinusförmiges Trägersignal ($Sig_{T90}$) zu addieren und ein phasenmoduliertes Signal ($Sig_{PM}$) zu erhalten,
- einen Begrenzer (11), dem das phasenmodulierte Signal ($Sig_{PM}$) zugeführt werden und mit dem eine Störamplitudenmodulation in dem phasenmodulierten Signal ($Sig_{PM}$) unterdrückt werden kann, und
- eine Demodulationseinrichtung (16), der das von dem Begrenzer (11) ausgegebene Signal ($Sig_{BA}$) zugeführt und darin mit wenigstens einem Abtast-Clocksignal (CLKO-CLK3) abgetastet werden kann,

in einer Eingangsschaltung (1) einer bevorzugt speicherprogrammierbaren Steuerung (S) oder in einer Eingangsschaltung eine Messvorrichtung, insbesondere eines Oszilloskops oder bevorzugt digitalen Multimeters.

FIG 1

FIG 2

# FIG 3

FIG 4

EP 4 675 928 A1

FIG 5

| CLK0 - 0° |
|---|
| CLK1 - 90° |
| CLK2 - 180° |
| CLK3 - 270° |

| CLK4 - int. Takt |
|---|
| CLK5 - „sin" |
| CLK6 - „cos" |

CLK7 - Sig$_{RF}$

FIG 6

## FIG 7

CLK0 - 0°
CLK1 - 90°
CLK2 - 180°
CLK3 - 270°
CLK4 - int
CLK5 - „sin"
CLK6 - „cos"
CLK7 - Sig$_{RF}$

**EUROPÄISCHER RECHERCHENBERICHT**

Nummer der Anmeldung

EP 24 18 6427

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,D | EP 3 624 334 A1 (SIEMENS AG [DE]) 18. März 2020 (2020-03-18)<br>* Absätze [0006] - [0007] *<br>* Absätze [0016] - [0018] *<br>* Absatz [0024] *<br>* Absätze [0026] - [0029] *<br>* Absatz [0036] *<br>* Absatz [0039] *<br>* Abbildungen 1,2 *<br>----- | 1-14 | INV.<br>H03M1/64<br>H03C1/52<br>H03C3/40 |

**RECHERCHIERTE SACHGEBIETE (IPC)**

H03M
H03D
H03C

Der vorliegende Recherchenbericht wurde für alle Patentansprüche erstellt

| Recherchenort | Abschlußdatum der Recherche | Prüfer |
|---|---|---|
| Den Haag | 19. Dezember 2024 | Rocha, Daniel |

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 24 18 6427

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-12-2024

| Im Recherchenbericht angeführtes Patentdokument | Datum der Veröffentlichung | Mitglied(er) der Patentfamilie | Datum der Veröffentlichung |
|---|---|---|---|
| EP 3624334 A1 | 18-03-2020 | EP 3624334 A1<br>WO 2020058049 A1 | 18-03-2020<br>26-03-2020 |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

**In der Beschreibung aufgeführte Patentdokumente**

- EP 3624334 A1